(19) Europäisches Patentamt
European Patent Office
Office européen des brevets

(11)  **EP 3 526 810 B1**

(12)  **EUROPEAN PATENT SPECIFICATION**

(45) Date of publication and mention
of the grant of the patent:
**10.11.2021  Bulletin 2021/45**

(51) Int Cl.:
*H01J 37/34* *(2006.01)*        *C23C 14/00* *(2006.01)*
*C23C 14/08* *(2006.01)*        *C23C 14/35* *(2006.01)*

(21) Application number: **17781065.2**

(22) Date of filing: **03.10.2017**

(86) International application number:
**PCT/EP2017/075078**

(87) International publication number:
**WO 2018/069091 (19.04.2018 Gazette 2018/16)**

(54)  **SPUTTERING SOURCE**

SPUTTERQUELLE

SOURCE DE PULVÉRISATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **14.10.2016  CH 13782016**

(43) Date of publication of application:
**21.08.2019  Bulletin 2019/34**

(73) Proprietor: **Evatec AG**
**9477 Trübbach (CH)**

(72) Inventors:
• **FELZER, Heinz**
**7302 Landquart (CH)**
• **JAEGER, Dominik**
**7000 Chur (CH)**
• **CHESEAUX, Michael**
**Stratford, Ontario N5A 4N3 (CA)**
• **ROHRMANN, Hartmut**
**69198 Schriesheim (DE)**

(74) Representative: **Troesch Scheidegger Werner AG**
**Schwäntenmos 14**
**8126 Zumikon (CH)**

(56) References cited:
**JP-A- S5 855 566        JP-A- S5 987 039
JP-A- S59 211 575        US-A1- 2008 308 417
US-A1- 2016 268 127**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

In the frame of manufacturing some types of electronic devices, e.g. light emitting diodes (LED), it is highly important to deposit oxide layers on substrates and thereby introducing as few as possible damages to the overall substrate. Such a covering oxide layer is often made out of a transparent conductive oxide (TCO).

These considerations may be generalized in that often layers have to be deposited thereby introducing as few as possible damages.

We understand throughout the present description and claims under a "substrate"

    a) A single, plane or bent, plate-shaped, single -or multilayered workpiece on which the oxide layer is to be deposited;

    b) A batch of more than one workpiece according to a) arranged to commonly define a plane or bent, plate-like arrangement.

We understand throughout the present description and claims under an "overall substrate", especially in context with the occurrence of damages, not only a "substrate" according to a) or b) but also the interface between such "substrate" and the oxide layer, more generically the material layer, being deposited or being about to be deposited thereon, as well as the oxide layer, more generically the material layer, itself being grown or having been grown thereon.

We understand thereby under the term "damage" primarily any change in the atomic structure or ordering of the atoms and/or molecules within the overall substrate due to the deposition process of the oxide layer, more generically of the material layer. This includes changes in the atomic bonding and in the next-neighbor ordering of the atoms. Such damages can be e.g. the loss of the crystalline structure, threading dislocation or ion implementation in the structure.

Attention is drawn to IEICE Trans. Electron., Vol.E91-C,No.10 October 2008,page 1658 ff. "Investigation of Low-Damage Sputter-Deposition of ITO Films on Organic Emission Layer", by Hao Lei, Keisuke ICHIKAWA et all. et all.

US 2008/308417 A1 discloses a sputter apparatus with a plasma heated anode preventing electric-discharge abnormalities.

It is an object of the present invention to provide a sputtering source conceived to sputter-coat a substrate with an oxide layer, more generically with a layer of a material at least one component thereof being present in the sputtering plasma as a negative ion, even more generically as a ion, as well as a sputter chamber with such a sputtering source, a sputtering system with such a sputtering source and/or with such sputter chamber and a method of coating substrates with an oxide layer, more generically with a layer of a material, at least one component thereof being present in the sputtering plasma as a negative ion, even more generically as a ion, or of manufacturing such coated substrate, whereat the occurrence of damages on the overall substrate is substantially reduced and which source, sputter chamber, sputter system and methods are applicable on industrial scale.

To achieve this object, there is proposed a sputtering source according to claim 1 conceived to sputter-coat a substrate. The sputtering source comprises:

Two plate shaped targets extending along respective plate-planes whereby the sputtering surfaces of these targets face each other and thereby define, in between, a reaction space. The plate-planes are mutually parallel or mutually inclined by at most 90°.In one embodiment the inclination is at most 5°. The sputtering source further comprises an anode arrangement and a magnet arrangement along each of the targets and located opposite to the respective sputtering surfaces of the targets. Each magnet arrangement generates a magnetic field in the reaction space whereby the magnetic field impinges on and/or emanates form and is distributed along at least a predominant part of the respective sputtering surfaces.

An open coating outlet area from the reaction space is limited by respective areas of mutually facing rims of the two plate-shaped targets.

The sputtering surfaces of the targets transit into respective side surface areas of the targets along the addressed mutually facing rims by or via respective transition surface areas of the targets. The transition surface areas have a smaller radius of curvature than the adjacent areas of the sputtering surfaces. Thereby, the radius of curvature as addressed is considered in planes perpendicular to the respective sputtering surface and perpendicular to the respective extended rim. The transition areas may be formed e.g. as corners which are sharp or more steadily curved and are in fact surface areas along the addressed rims at which an electric field generated between the anode arrangement and the respective target has a local maximum of strength.

There is further provided at the sputtering source according to the invention a catcher plate arrangement along each of the addressed rims and distant from the respective one of the targets. Each catcher plate arrangement projects in direction from the addressed rim towards the other rim, into the open coating outlet area and thereby restricts the effective opening of the open coating outlet area, beneath that extent which is limited merely by the mutually facing rims of the two plate-shaped targets. It is this restricted open coating outlet area which is exploited as "source output" for coating material to be deposited on the substrate.

The inventors have recognized, that particles which originate from sputtering in the transition surface area as ions, or which pass as ions nearby the transition surface area impinge with substantially higher energies on the overall substrate, than other particles out of the reaction space. Some possible explanations of this phenomenon are given below. The catcher plate arrangements do prevent at least a substantial part of such higher energy particles to impinge on the overall substrate.

By the fact, that the catcher plate arrangement projects in direction from one addressed target rim towards the other target rim, into the open coating outlet area and thereby restricts the effective opening of the open coating outlet area, it is substantially avoided, that surfaces of the catcher plate arrangement which are exposed to the space opposite the reaction space, with respect to the open coating outlet area or to the "source output", are spoiled by sputtered off and possibly reacted material deposition. Thereby it is substantially avoided that such material peeling or flaking off the catcher plate arrangement becomes deposited on a workpiece or substrate to be treated by the sputtering source.

Thereby uptimes of the sputtering source up to cleaning maintenance are considerably lengthened.

In one embodiment the sputtering source according to the invention is constructed to sputter coat the substrate with a material at least one component thereof being present in the sputtering plasma as a ion.

In one embodiment the sputtering source according to the invention is constructed to sputter coat the substrate with a material at least one component thereof being present in the sputtering plasma as a negative ion.

In all the embodiments the sputtering source according to the invention is constructed to sputter coat the substrate with an oxide.

In all the embodiments of the sputtering source, the addressed peeling or flaking off problem is even practically eliminated. The projecting catcher plate arrangement has thereby a surface. This surface predominantly consists on one hand of a first surface area and of a second surface area. The first surface area is exclusively exposed to the reaction space and thus not to the space opposite the reaction space with respect to the open coating outlet area or to the "source output". The second surface area is exclusively exposed to the space opposite the reaction space with respect to the open coating outlet area or to the "source output" thus not to the reaction space. The overall surface of the projecting catcher plate arrangement may comprise additional surface areas, which are neglectable, even if exposed to both spaces as addressed.

In one embodiment of the sputtering source each catcher plate arrangement has a most projecting rim. A distance from such most projecting rim to a side surface of the respective target, measured in a plane parallel to the respective plate plane and perpendicularly to the length extent of the most projecting rim, is smaller than a distance between the most projecting rim and a surface of the respective target, measured in a plane perpendicular to the respective plate plane and perpendicular to the length extent of the most projecting rim.

Thereby the transition surfaces of the targets are hidden seen from a large area or volume opposite the reaction space, with respect to the restricted open coating outlet area.

In one embodiment of the sputtering source according to the invention, the plate-planes extend symmetrically to a central plane. This facilitates mutual positioning of the sputtering source with respect to a substrate to be coated as well as the overall construction of the sputtering source.

In one embodiment of the sputtering source according to the invention, the plate-planes are parallel, which further simplifies overall construction of the sputtering source.

In spite of the fact that the two mutually facing rims of the two targets may extend along differently shaped curves or along equally shaped curves, in one embodiment of the sputtering source according to the invention the mutually facing rims extent along straight lines and are thus linear and are, additionally, parallel. Thereby, the open coating outlet area becomes a slit, which extends along a plane. This allows relatively simple and accurate positioning with respect to a substrate, especially if the substrate extends along a plane as well.

In one embodiment of the sputtering source according to the invention the plate-shaped targets are rectangular or square which again simplifies the overall construction of the sputtering source especially with a consideration on the magnet arrangements complexity.

In one embodiment of the sputtering source according to the invention, the plate-planes are symmetrical to a central plane and the open coating outlet area extends along a plane which is perpendicular to the central plane.

In spite of the fact that both targets may be made of one equal material or each of the targets may be made, respectively, of one material but the materials being different materials, or at least one of the targets may comprise an area of one material and another area of a different material, in one embodiment of the sputtering source at least one of the targets is of a single material.

Sputter deposition of an oxide layer from the sputtering source according to the invention may be performed exclusively by reacting sputtered-off metal. In this case the component of the deposited layer material which is present in the sputtering plasma as a ion, namely as a negative ion, is oxygen.

The sputtered off metal may be deposited on the substrate and reacted there with oxygen, more generically with a gas at least one component thereof being present in the sputtering plasma as a negative ion, even more generically as a ion, or the sputtered off metal may be reacted with such gas in the reaction space and/or in a space between the restricted open coating outlet area and the substrate.

In one embodiment of the sputtering source according to the invention, at least one of the targets comprises an oxide or consists of an oxide.

In one embodiment of the sputtering source according to the invention at least one of the targets comprises a material component which is present in the sputtering plasma as a ion.

In one embodiment of the sputtering source according to the invention at least one of the targets comprises a material component which is present in the sputtering plasma as a negative ion.

In one embodiment of the sputtering source according to the invention there is provided an oxygen gas feed arrangement which discharges into the reaction space and /or downstream the restricted open coating outlet area, restricted by the catcher plate arrangements.

One embodiment of the sputtering source according to the invention comprises a gas feed arrangement discharging into the reaction space and/or downstream the restricted open coating outlet area, restricted by said catcher plate arrangements. By such gas feed a gas, at least one component thereof being present in the sputtering plasma as a ion, especially as a negative ion, e.g. as the addressed oxygen is supplied to the source. A working inert gas for the sputtering, e.g. argon, is fed to the reaction space.

In one embodiment of the sputtering source according to the invention, the catcher plate arrangements comprise catcher plates of at least one of the following shapes: plane, bent towards the reaction space, bent away from the reaction space.

In one embodiment of the sputtering source according to the invention, at least one of the catcher plate arrangements comprises at least one metal plate or consists of at least one metal plate.

On a catcher plate arrangement comprising more than one metal plates, a selected electrical potential distribution may be realized along the catcher plate arrangement.

In one embodiment of the sputtering source according to the invention, at least one of the catcher plate arrangements comprises at least one ceramic material plate or consists of at least one ceramic material plate.

Such an embodiment may be advantageous if the coating material, as an oxide material, is an electrically isolating material.

In one embodiment of the sputtering source according to the invention, the anode arrangement comprises a lateral anode plate, which complements the two-side delimitation of the cross section through the reaction space, by the two targets, to a three-side delimitated cross section of the reaction space.

In one embodiment of the sputtering source according to the invention, the anode arrangement comprises two of the just addressed lateral anode plates thereby complementing the two-side delimitation of the cross section through the reaction space, by the two targets, to a four-side delimitated cross section of the reaction space.

In one embodiment of the sputtering source according to the invention, the anode arrangement comprises a lateral anode plate, complementing the two-side delimitation of the open coating outlet area, by the two targets, to a three-side delimitation of the open coating outlet area. In this embodiment, the lateral anode plate extends down to or just adjacent to the open coating outlet opening area.

In one embodiment of the sputtering source according to the invention the anode arrangement comprises two of the just addressed lateral anode plates, complementing the two-side delimitation of the open coating outlet area, by the two targets, to a four-side delimitation of the open coating outlet area.

In one embodiment of the sputtering source according to the invention, the anode arrangement comprises an anode plate, opposite to the open coating outlet area with respect to the reaction space.

In one embodiment of the sputtering source according to the invention, the anode arrangement comprise an anode frame around the open coating outlet area.

By two lateral anode plates and the anode plate opposite the open coating outlet area in combination, the overall anode arrangement becomes similar to an anode box opened along the open coating outlet opening area.

By one lateral anode plate and the anode plate opposite the open coating outlet area in combination, the overall anode arrangement becomes an L profile.

In a further embodiment of the sputtering source according to the invention, the overall anode arrangement comprises an arrangement of anode strips along the border of the targets and exclusively along the mutually facing rims. Thus no anode strips are provided along the remaining border of the targets in opposition to customary anode arrangements which form a frame around the targets.

In a further embodiment of the sputtering source according to the invention, the overall anode arrangement comprises an arrangement of anode strips along the mutually facing rims, the catcher plate arrangements comprises projecting metal plates electrically and mechanically connected to the anode strips.

In a further embodiment of the sputtering source according to the invention, the catcher plate arrangements comprises projecting metal plates electrically connected to the overall anode arrangement.

In one embodiment of the sputtering source according to the invention the catcher plate arrangements are two legs of a frame limiting the and around the open coating outlet area.

In one embodiment of the sputtering source according to the invention, the magnetic field is generated uni-directionally from one sputtering surface to the other sputtering surface of the respective targets.

Nevertheless, the addressed magnetic field may also be tailored as a at least partly unbalanced field from one or from both of the targets or as a bi- directional field between respective sputtering surfaces or even comprising magnetron-type magnetic field.

One embodiment of the sputtering source according to the invention comprises a third target covering the reaction space opposite the open coating outlet area.

In one embodiment of the sputtering source according to the invention the third target is associated with a magnet arrangement generating along the sputter surface of the third target a magnetron-type magnetic field.

In one embodiment of the sputtering source according to the invention, at least one of the targets comprises or consists of at least one of the metals In, Sn, Zn, Ga, Al.

In one embodiment of the sputtering source according to the invention at least one of said targets comprises a material component which is present in the sputtering plasma as a ion.

In one embodiment of the sputtering source according to the invention at least one of said targets comprises a material component which is present in the sputtering plasma as a negative ion.

In one embodiment of the sputtering source according to the invention at least one of said targets comprises or consists of an oxide.

In one embodiment of the sputtering source according to the invention the plate-planes are mutually inclined by at most 5°.

Every embodiment of the sputtering source as addressed above may be combined with one or more than one of the other addressed embodiments unless such combinations are in contradiction.

The present invention is further directed to a sputter coating chamber which comprises at least one sputtering source according to the invention or according to at least one of its embodiments.

The sputter coating chamber further comprises a substrate holder, which is constructed to hold a substrate with one of its extended surfaces exposed to the surrounding gaseous environment. The substrate holder is mounted in the sputter chamber in a position in which the extended surface of the substrate faces the restricted open coating outlet area of the sputtering source. Visibility of the transition surface areas from at least a predominant part, i.e. from more than 50% of the extended surface, is bared or blocked by the catcher plate arrangements of the sputtering source.

In one embodiment of the sputter coating chamber the substrate holder is constructed to hold a substrate along a holding-plane. The mutually facing rims of the sputtering source are parallel and linear and the holding-plane is parallel to or inclined with respect to a plane defined by the parallel and linear rims.

Thereby and in a further embodiment, the holding-plane and the plane defined by the two rims of the targets are inclined by at most 45°.

In spite of the fact that a substrate on the substrate holder may be operated at any desired electric bias potential, in one embodiment of the sputter coating chamber the substrate on the substrate holder is operated in electrically floating manner or is connected to a DC-reference potential, thereby, in a further embodiment, to ground potential.

In one embodiment of the sputtering coating chamber, the substrate holder is constructed to hold a circular substrate and is operationally connected to rotary drive. By this rotary drive the holder and thus the substrate is rotated about a central axis. Thereby, homogeneity of coating deposition on the substrate is improved.

In a further embodiment of the just addressed embodiment of the sputter coating chamber, there is provided a substrate holder carrier with at least two of the addressed substrate holders. The number of the sputtering sources provided at the sputter coating chamber is thereby equal or is different from the number of the at least two substrate holders of the substrate holder carrier. The sputter coating chamber may be conceived as an inline sputter chamber or as a batch sputter chamber.

Each embodiment of the sputter coating chamber as addressed above may be combined with one or more than one of the other embodiments of the chamber unless such combination being in contradiction.

The present invention is further directed to a sputtering system which comprises at least one sputter source according to the invention, possibly according to one or more than one of the respectively addressed source-embodiments or which comprises at least one sputter chamber according to the invention, possibly according to one or more than one of the chamber embodiments. The system further comprises a gas feed arrangement which delivers a gas into the reaction space of the at least one sputtering source and/or between the open coating material outlet area of the sputtering source and the substrate holder.

In one embodiment of the sputtering system according to the invention the gas feed arrangement is in operational flow connection with a gas reservoir arrangement containing a gas, the gas or at least one component thereof being present in the sputtering plasma as a ion.

In one embodiment of the sputtering system according to the invention the gas feed arrangement is in operational flow connection with a gas reservoir arrangement containing a gas, the gas or at least one component thereof being oxygen.

In one embodiment of the sputtering system according to the invention at least one of the targets is electrically supplied by at least one supply source generating at least one of a DC-, a pulsed DC-, a RF-supply. Both targets may be electrically supplied commonly by one supply source or each of the targets may be separately electrically supplied, equally or differently.

The present invention is further directed to a method according to claim 49, the method involving sputter coating a substrate with a material, at least one component thereof being present in the sputtering plasma as a ion, and/or to a method of manufacturing a substrate coated with the addressed material. The methods comprise applying the coating by means of at least one sputtering source according to the invention, possibly according to one or more than one of the source-embodiments or by means of a sputter chamber according to invention, possibly according to one or more than one of the chamber- embodiments or by a system according to the invention, possibly according to one or more than one of the system-embodiments, all addressed above.

One variant of the methods according to the invention comprises coating the substrate with a material, at least one component thereof being present in the sputtering plasma as a negative ion.

One variant of the methods according to the invention the substrate is coated with an oxide.

In one variant of this method ions having an energy of at least $0.5 \, U_{AC} \times e^-$ are blocked from impinging on the substrate by the catcher arrangements of the sputtering source. Thereby, the $U_{AC}$ is the time average of the absolute value of the anode/target (cathode) voltage applied to the respective target, as both targets need not necessarily be operated at the same $U_{AC}$ voltage. The addressed energy limit shall prevail separately for both targets. $e^-$ is the electric charge of an electron.

The invention shall now be further explained by examples and with the help of figures.

Please note that we refer in the following description to oxygen as an example of a component of sputter-deposited material, which component is present in the sputtering plasma as a ion, more specifically as a negative ion. Accordingly we refer to oxide layers.

The Figures show:

Fig. 1 shows most generically and simplified, in a cross-sectional representation, an embodiment of a sputtering source according to the invention, which may be built in a sputtering chamber according to the invention, as well as in a system according to the invention, to perform the manufacturing method of the invention,

Fig. 2a to Fig.2d: schematically, different rim shapes of targets of the sputtering source according to the invention,

Fig. 3: schematically, two targets of different plate shapes, of an embodiment of the sputtering source according to the invention,

Fig. 4: schematically, two targets of different plate shapes, of an embodiment of the sputtering source according to the invention, with liner and parallel neighboring rims,

Fig. 5: schematically, two targets of an embodiment of the sputtering source according to the invention;

Fig. 6 to Fig. 9: schematically, two targets of four embodiments of the sputtering source according to the invention with respective mutual positioning of the targets;

Fig. 10: schematically, a rim portion of a target of an embodiment of the sputtering source according to the invention, cooperating with a substrate in a sputter chamber according to the invention;

Fig. 11: schematically, a top view on an embodiment of the sputtering source according to the invention, with an anode arrangement;

Fig. 12: schematically, a side view on an embodiment of the sputtering source according to the invention, with an anode arrangement;

Fig. 13: schematically, a perspective view of an embodiment of the sputtering source according to the invention, with an anode arrangement;

Fig. 14: schematically, an embodiment of the sputtering source according to the invention, with an anode arrangement;

Fig. 15: schematically, an embodiment of the sputtering source according to the invention;

Fig. 16: schematically, an embodiment of the sputtering source according to the invention;

Fig. 17: schematically, an embodiment of the sputtering source according to the invention in more details;

Fig. 18: schematically, an embodiment of the sputtering source according to the invention with an additional target;

Fig. 19 and fig.20: schematically, a side and a top view on a part of an embodiment of a sputter chamber according to the invention;

Fig. 21 and fig.22: schematically, and in representations in analogy to those of figs. 19 and 20, an embodiment of a sputter chamber according to the invention;

Fig. 23 and fig.24: schematically, and in representations in analogy to those of figs. 21 and 22, an embodiment of a sputter chamber according to the invention;

Fig. 25 and fig.26: schematically, and in representations in analogy to those of figs. 23 and 24, an embodiment of a sputter chamber according to the invention;

Fig. 27: a schematic representation of an embodiment of the sputter chamber according to the invention and of different possibilities of electric supplying.

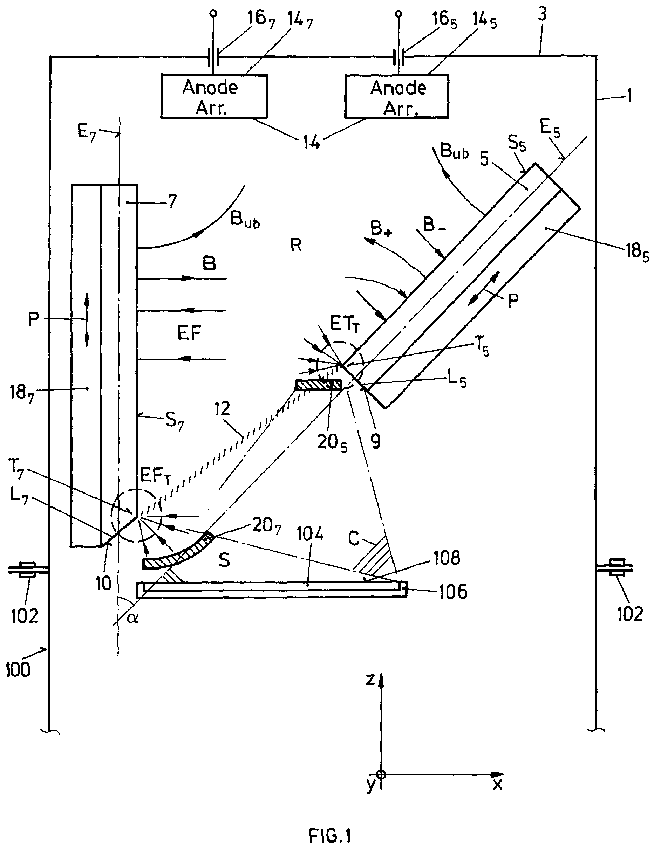

As most schematically shown in Fig. 1, the sputtering source 1 in the addressed embodiment comprises, within a vacuum tight enclosure 3, a first target 5 and a second target 7. Each of the targets is plate shaped and extends along a respective plate-plane $E_5$, $E_7$. The sputtering surfaces $S_5$ and $S_7$ face each other. In the embodiment shown in Fig. 1 the plate-planes $E_5$, $E_7$ are mutually inclined whereby the angle $\alpha$ of mutual inclination is at most 90°. In another embodiment, the plate-planes $E_5$ and $E_7$ are parallel. The sputtering surfaces $S_5$ and $S_7$ delimit, in between, two sides of a reaction space R.

The targets 5 and 7 have each a rim portion 9 and 10, which are neighboring each other and face towards each other. These two rim portions 9 and 10 two-side delimit an open coating-material outlet area 12 represented in Fig. 1 by hatched line. Along these rim portions which delimit the open coating-material outlet area 12 of the sputtering source 1 ,the respective sputtering surfaces $S_5$ and $S_7$ transit into side surfaces $L_5$ and $L_7$ by respective transition surface areas $T_5$ and $T_7$, highlighted in fig.1 by dashed circles.

Dependent on the shape and orientation of the side surfaces $L_5$ and $L_7$ of the targets 5 and 7, the transition areas $T_5$ and $T_7$ may exhibit different radii r of curvature. Nevertheless, such radii r are always smaller than the radius of curvature of the adjacent areas of the respective sputtering surfaces $S_5$ and $S_7$ which is, if this adjacent area is plane, infinite. The radii r of curvature are considered in a cross sectional view perpendicularly through the respective elongated rim portions 9 and 10 of the targets 5 and 7 and perpendicularly to the sputtering surfaces $S_5$ and $S_7$.

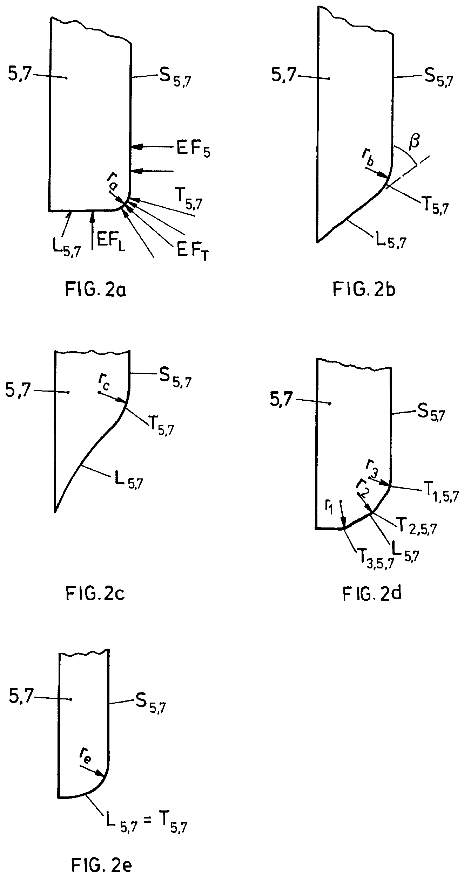

Figs. 2a to 2e show different examples of rim portions 9, 10 of the targets 5, 7.

According to Fig. 2a the sputtering surface $S_{5,7}$ transits in the side surface $L_{5,7}$ which extends perpendicularly to the sputtering surface $S_{5,7}$ via the transition surface area $T_{5,7}$ realized as an edge with a radius of curvature $r_a$.

According to Fig. 2b the sputtering surface $S_{5,7}$ transits in the side surface $L_{5,7}$, which is inclined to the sputtering surface by an angle $\beta$ smaller than 90° via the transition surface area $T_{5,7}$ realized as gently bent surface area with a radius of curvature $r_b$.

According to Fig. 2c the sputtering surface $S_{5,7}$ transits in the side surface $L_{5,7}$, which is rolling from the sputtering surface $S_{5,7}$ via the transit surface area $T_{5,7}$ realized as gently bent surface area with a radius of curvature $r_c$.

According to Fig. 2d the sputtering surface $S_{5,7}$ transits in the side surface $L_{5,7}$, which has a polygonal profile form via multiple transit surface area $T_{1,5,7}$ to $T_{3,5,7}$ realized by edges of respective small radii of curvature $r_{1,2,3}$.

According to Fig. 2e the sputtering surface $S_{5,7}$ transits in the side surface $L_{5,7}$, which is shaped as an arc of a circle from the sputtering surface. In this case the transit surface and the side surface $L_{5,7}$, are identical, realized with one radius of curvature $r_e$.

As may be seen there exists always along the rim portions 9 and 10, delimiting the open coating material outlet area 12 at least one transition surface area T which has a radius of curvature as defined above which is smaller than the radius of curvature of the sputtering surfaces adjacent and along the rim portions 9,10.

Under the general aspect of the sputtering source 1 according to the invention, and as shown in the embodiment of Fig. 1 the plate shaped targets 5,7 need not be of equal plate shape. One thereof may e.g. be circular, the other elliptical. Nevertheless in a today realized embodiment and as will be addressed later, both plate-shaped targets are of equal shape, namely of rectangular or square shape. Further and even if the plate-shaped targets 5,7 are of different shape, in one embodiment, in fact also realized at the today practiced embodiment with rectangular or square targets, at least the rim portions 9 and 10 extend linearly in the y direction shown in Fig. 1 and are, in a further embodiment, parallel.

Further and independent of the shape of the plate-shaped targets 5, 7 along their extended sputter surfaces $S_{5,7}$ the rim 9 portion of the one target 5 may be shaped differently from the rim portion 10 of the target 7, considered in cross sectional representation as e.g. shown in Fig. 2.

The sputtering source 1 further comprises respective anode arrangements $14_5$ and $14_7$, which may be combined to one single anode arrangement 14, operative for both targets 5 and 7.

Please note that the "anode" blocks shown in Fig. 1 do not represent the locations and shapes of anodically operated members in the sputtering source 1 but do merely address presence of respective anodes. The anode arrangement $14_5$ and $14_7$ or 14 may be electrically supplied via feed-troughs $16_{5,7}$ as shown in fig 1. Alternatively or additionally the enclosure 3 may act as an anode with respect to the targets, operated as cathodes.

In any case, electrically operating the anode arrangement 14, $14_5$, $14_7$ and the plate-shaped targets 5,7 as cathodes results in an electric field EF on the sputtering surfaces $S_5$ and $S_7$.

As was addressed above, the inventors have recognized, that particles which originate from sputtering in the transition surface area as ions, or which pass as ions nearby the transition surface area impinge with substantially higher energies on the overall substrate, than other particles out of the reaction space.

In one possible explanation of this phenomenon, this electric field EF is more closely to be considered along the rim portions 9 and 10. As represented in Fig. 2a the strength of electric field EF which impinges perpendicularly on the sputtering surfaces $S_{5,7}$ and which is customarily represented by the density of field lines , has a local maximum along the transition surface areas $T_{5,7}$ due to their reduced radius r of curvature. As known to the skilled artisan, this local maximum $EF_T$ of the strength of the electric field EF becomes the more pronounced the smaller that the radius r of curvature at the transition surface area is selected, relative to the radius of curvature of the area of the sputtering surface just adjacent the transition surface area. This radius is in fact infinite if the addressed sputtering surface is plane.

Thus and as there exists always along the rim portions 9 and 10, delimiting the open coating material outlet area 12, at least one transition surface area T which has a radius of curvature smaller than the radius of curvature of the sputtering surfaces along the rim portions 9, 10, there exists always a local maximum of electric field strength along the addressed rim portions 9, 10.

This local maximum of electric field strengths may be one reason of the addressed phenomenon.

Another or an additional reason may be that the energetic ions are accelerated in the reaction space. In a normal operation, the strongest electric field is found in the vicinity of the targets. There the electric field is perpendicular to the target. Therefore, the majority of those energetic ions potentially reaching the substrate start their trajectories perpendicularly to the target surface in the vicinity of which they were first accelerated. These ions can have their trajectory deflected and be repelled by negative potentials, as for example by another target. Thus most of those ions could bounce between both targets multiple time until leaving the reaction area. However for energetic ions generated in the vicinity of the transition area or energetic ions deflected in the transition area, the local curvature of the transition area makes that those energetic ions trajectories are more likely to directly point towards the substrate and are therefore more likely to reach it.

Under this explanation too the shapes of the targets in this transition areas have therefore an impact upon the path of the energetic ions towards the substrate and therefore ultimately upon the quantity of energetic ions reaching the substrate.

The targets 5, 7 are operatively linked to respective magnet arrangements $18_5$ and $18_7$ which generate through the reaction space R a magnetic field B along at least a predominant part of the sputtering surfaces $S_5$ and $S_7$. Under the generic approach according to fig 1, this magnetic field B may be unbalanced $B_{ub}$ with respect one or to each target 5,7, may be bidirectional at each of the targets , may extend bidirectionally from one target to the other target or may extend uni-directionally from one target to the other target. Latter is realized in the today practiced embodiment.

By the sputtering source substrates 104 shall be coated with an oxide layer. Therefor at least one of the targets 5,7 is of a metal-oxide and /or there is provided a gas feed arrangement (not shown in Fig. 1) feeding oxygen gas into the reaction space R and/or downstream the open coating-material outlet area 12 along the substrate 104 to be coated in the sputtering chamber 100. The sputtering source 1 according to the invention is mounted, as schematically shown in Fig. 1 at 102, to the sputtering chamber 100.

The sputtering source 1 further comprises a catcher plate arrangement $20_7$ and $20_5$ along each of and distant from the rim portions 10 and 9 of the respective targets 7,5.

The catcher plate arrangements $20_5$ and $20_7$ extend all along the rim portions 9 and 10 respectively and project from the respective targets or their plate-planes $E_{5,7}$ towards each other. With respect to the reaction space R they are positioned opposite the open coating material outlet area 12 and thus in fact restrict or downsize the open area of the open coating-material outlet area 12 which is open towards the substrate 104.

Within the sputtering chamber 100 there is provided a substrate holder 106 which is constructed to hold and position the substrate 104, at least during sputter-coating operation by the sputtering source 1, in coating position. This coating position is distant from and opposite the restricted open coating material outlet area 12, restricted by the catcher plate arrangements $20_{5,7}$.

The catcher plate arrangements $20_{5,7}$, the substrate holder 106 are mutually positioned so, that the transition surface areas $T_{5,7}$ are invisible from any point of or at least the predominant part of the exposed surface 108 of the substrate 104. The catcher plate arrangements block all lines of sight from any point or at least of the addressed predominant part of the surface 108 to the transition surface areas $T_{5,7}$.

In Fig. 1 the space blocked by the respective catcher plate arrangements is schematically shown by dash-dotted lines at C.

As was already addressed high-energy particles impinging on the surface 108 during its sputter-coating cause local damage to the overall substrate. The occurrence of such damages is avoided by catching these high energy particles by means of the catcher plate arrangements $20_{5,7}$.

Additionally, local damages to the substrate 104 and/or to the oxide layer on surface 108 may also be caused by flaking off of particles from sputter coated members of the sputtering source 1, the thickness thereof increasing during maintenance intervals.

Therefore and as may be seen from the embodiment of Fig. 1 those surfaces of the catcher plate arrangements $20_{5,7}$ which are exposed to sputter coating from the reaction space R are not exposed, are hidden from the surface 108 of the substrate and thus from the substrate holder 104. Vice versa, those surfaces of the catcher plate arrangements, which are exposed to the surface 108 of the substrate 104 and thus to the substrate holder 106, are not exposed and thus hidden from the reaction space R.

After having explained the sputtering source 1 and the sputtering chamber 100 in generic terms and with the help of the figs. 1 and 2 we will address different embodiments specifically in context with specific features of the source and/ or chamber.

## 1. Shape of the plate-shaped targets 5,7:

As we have already addressed above the plate shape of the one target may be different from the plate shape of the other target. Thus e.g. a circular target 5 may cooperate witch an elliptical target 7.

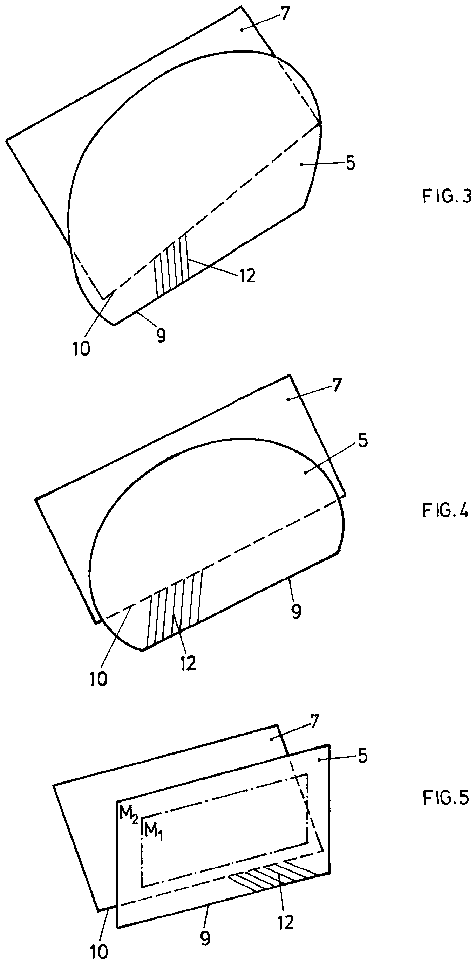

In today practiced embodiment both targets have a linear extended rim portion 9, 10. Such linearly extended rim portions may be provided irrespective of the overall plate shapes of the respective targets, as shown in Fig. 3 or Fig. 4 showing the targets 5 and 7 of different shapes with linearly extended rim portions 9, 10 schematically and in a perspective view.

In the today practiced embodiment the linearly extended rim portions 9 and 10 are additionally parallel. Such parallelism may also be practiced irrespective of the plate shape of the plate-shaped targets 5, 7 as schematically shown in Fig. 4.

In today practiced embodiment both targets are rectangular plates, and are, additionally, of equal extent, as shown in the embodiment of Fig. 5.

## 2. Mutual orientation of the plate-shaped targets 5,7

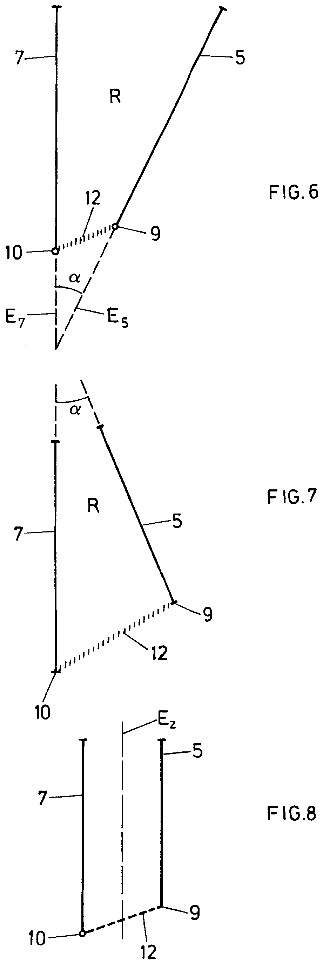

As shown in Fig. 1 and schematically represented in Fig. 6 the plate-planes $E_{5,7}$ of the mutually facing targets 5,7 may be mutually inclined by an angle $\alpha$. This inclination angle $\alpha$ is at most 90°. As shown in the addressed figures and due to this inclination angle, the reaction space R becomes in such embodiment narrower towards the open coating material outlet area 12.

In the embodiment of Fig. 7 the plate-planes $E_{5,7}$ and the targets 5,7 are again mutually inclined by the inclination angle $\alpha$ of at most 90° but the reaction space is widened towards the open coating-material outlet area 12.

In the embodiment of Fig. 8 the plate-planes $E_{5,7}$ are parallel, parallel to a central plane Ez , which accords with the embodiment as practiced today.

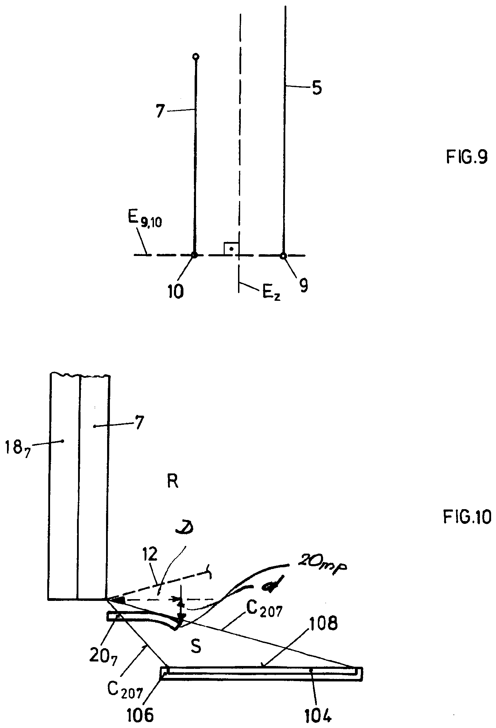

In the embodiment of Fig. 9 the plate-planes $E_{5,7}$ are parallel, parallel to a central plane Ez and the rim portions 9,10 extend in a plane $E_{9,10}$ which is perpendicular to the central plane Ez.

## 3. Oxide-deposition, material of targets 5, 7

So as to sputter deposit oxide layers on the substrate 104, two basic possibilities prevail.

The first one is to exploit targets of different or equal oxide material. The second one is to exploit both targets of same or different metals and to react the respectively sputtered off metals in an oxygen containing atmosphere in the reaction space R and/ or in the space S (see fig.1) of the sputtering chamber 100 between the open coating-material outlet area 12 and the substrate holder 106. Both possibilities may be combined e.g. by exploiting one target of an oxide material, the second of a metal and reacting the sputtered off materials in the reaction space R and/or in the space S between the open coating-material outlet area 12 and the substrate 104 on the substrate holder 106 of the sputtering chamber 100.

Further one target considered may be of different materials, e.g. one section of a metal, a second section of an oxide. This is schematically shown in fig. 5 by the dash-dotted sections $M_1$ and $M_2$ at target 5.

Deposition of oxide layers with as few as possible damages is particularly important in depositing TCO, Transparent, Conductive Oxide layers, as e.g. used in context with manufacturing of opto-electric devices as of LED devices or photovoltaic devices.

Particularly layers of ITO, ZnO, GZO are today of high interest. Thus and with an eye on the addressed possibilities for deposition the oxide layers in the respective embodiments of the sputtering source 1, the targets 5,7 comprise or consist of at least one of the metals In, Sn, Zn, Ga, Al and/or of at least one oxide of at least one of these metals. If purely reactive sputter coating is applied from sputtered metal, oxygen gas or an oxygen containing gas is fed to at least one on the reaction space R and of the chamber space S. For mixed oxide deposition one target may be of the one metal, as of In or Ga the other of the second metal as of Sn or Zn and/or of an oxide.

Also a mixed target type may be applied where e.g. the inner section $M_1$ of the target is e.g. Sn and the outer section $M_2$ is e.g. of Zn or of SnO.

## 4. Catcher plate arrangements $20_{5,7}$

The catcher plate arrangements $20_{5,7}$ extend each all along and distant from the rim portions 9 and 10 of the targets 5,7. Each may be of a single plate member or of more than one plate member mounted one subsequent the other along and distant from the respective rim portion 9,10. To fulfill the object of catching high energy particles originating from sputtering of or bypassing nearby the transition surface areas $T_{5,7}$ of the targets 5,7 the catcher plate arrangements $20_{5,7}$ may be of any desired material which withstands thermal loading by the sputtering process. Especially if the oxide coating material is an electrically insulating material, ceramic material may be used for at least a part of the catcher plate arrangements $20_{5,7}$. Nevertheless, in one embodiment, at least the predominant part of the catcher plate arrangements $20_{5,7}$ is of metal.

Made of metal, the catcher plate arrangements $20_{5,7}$ may be operated on respectively desired electric potential e.g. on DC-, pulsed DC- or AC -as of RF- potential. The electric potentials applied to the catcher plate arrangements $20_{5,7}$ may be equal for both arrangements $20_5$ and $20_7$, or may be different. If at least one of the catcher plate arrangements $20_{5,7}$ is built from separate metal plates, a desired electric potential distribution may be applied along such catcher plate arrangement. Nevertheless, and as often most high energy particles from the transition surface areas $T_{5,7}$ are still negative ions when they arrive at the catcher plate arrangements, in one embodiment both catcher plate arrangements $20_{5,7}$ of metal are operated on a positive- i.e. an anodic- electric DC potential with respect to the targets 5,7. In one embodiment both catcher plate arrangements $20_{5,7}$ are operated on the common anode potential of the common anode arrangement 14. In another embodiment one catcher plate arrangement $20_5$ is operated on the potential of the associated anode arrangement $14_5$ and/or the second catcher plate arrangement $20_7$ is operated on the potential of the associated anode arrangement $14_7$.

The catcher plate arrangements $20_{5,7}$, are plane plates or sets of plane plates or of plates bent towards the reaction space R as shown in Fig. 1 at catcher plate arrangement $20_7$ and/or of plates bent - as shown in Fig. 10 - from the reaction space R away towards the chamber space S. The catcher plate arrangements $20_{5,7}$ project towards each other, and thus restrict the area of the open coating-material outlet area 12 remaining open towards the space S and thus towards the substrate 104 on the substrate holder 106. The catcher plate arrangements $20_{5,7}$ restrict the open coating-material outlet area 12 just by a degree high enough to bar or block the addressed visibility between the transition surface areas $T_{5,7}$ and the predominant part of the extended surface 108 of a the substrate 104 on the substrate holder 106, even to the entire extended surface 108.

With the help of fig.10 a geometric relationship shall be explained. This is done with the help of fig.10 but it must be emphasized, that the following explanations are valid for all embodiments of the invention. Each of the catcher plate arrangements $20_7$ has an extended most projecting rim or border 20mp.

A distance of this most projecting rim $20_{mp}$ to the respective side surface 9,10 of the respective target is shown by d. This distance is measured parallel to the respective plate plane $E_5$ or $E_7$ respectively and perpendicularly to the extent of the most projecting rim $20_{mp}$ which extents substantially in a direction perpendicular to the plane of fig.10.

A further distance of the most projecting rim $20_{mp}$ to the respective target 7,5 is shown by D. This distance is measured in a plane perpendicular to the respective plate plane $E_5, E_7$ and again, as was defined, perpendicular to the extent of the most projecting rom.

There is valid in all embodiments of the invention:

$$d \leq D$$

and in a good embodiment

$$d < D.$$

One should thereby keep in mind that surfaces of the catcher plate arrangements $20_{5,7}$ which are exposed to both, the reaction space R and the extended surface 108 should be kept minimal or even vanishing. This because, as was addressed above, the surfaces of the catcher plate arrangements exposed to the reaction space R will become coated with a coating thickness increasing with operation time of the sputtering source. If these surfaces are also exposed to the extended surface 108 of the substrate 104, flaking off may result in damaging the overall substrate. In one embodiment the catcher plate arrangements $20_{5,7}$ are constructed and mounted as maintenance exchange parts.

## 5. Anode arrangement 14, $14_{5,7}$

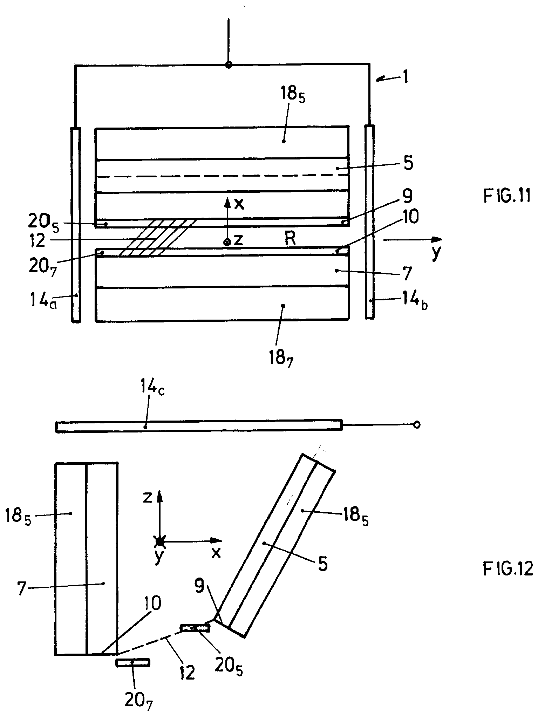

Fig. 11 shows, schematically and simplified, a top view of one embodiment of the sputtering source 1. The anode arrangement 14 comprises at least one, in the embodiment of fig 11 two anode lateral plates $14_a$ and $14_b$, which complement the delimitation of the reaction space R, two side delimitated by the targets 5 and 7, to a four side delimitation. If, considered in z direction, the two anode lateral or side plates $14_a$ and $14_b$ extend down to or are located just adjacent the rim portions 9 and 10, they complement the delimitation of the open coating material outlet area 12, two side delimitated by the rim portions 9 and 10, to a four side delimitation. Only one lateral plate e.g. plate $14_a$ may be provided e.g. if the wall of the sputtering source is operated as anode and is located laterally nearby the targets, at the location and instead of lateral plate $14_b$ of fig.11.

Clearly if only one lateral plate is provided, respectively the reaction space and the open coating material outlet area becomes three side delimitated by such single lateral plate.

Fig. 12 shows, schematically and simplified, a side view in analogy to that of Fig. 1, on an embodiment of the sputtering source 1. In this embodiment the anode arrangement 14 comprises a top anode plate $14_c$ opposite to the open coating-material outlet area 12, with respect to the reaction space R. If such a top plate $14_c$ is combined with a single lateral plate e.g. $14_a$ then the anode arrangement becomes L-profiled, combined with two lateral plates $14_a$ and $14_b$, U-profiled.

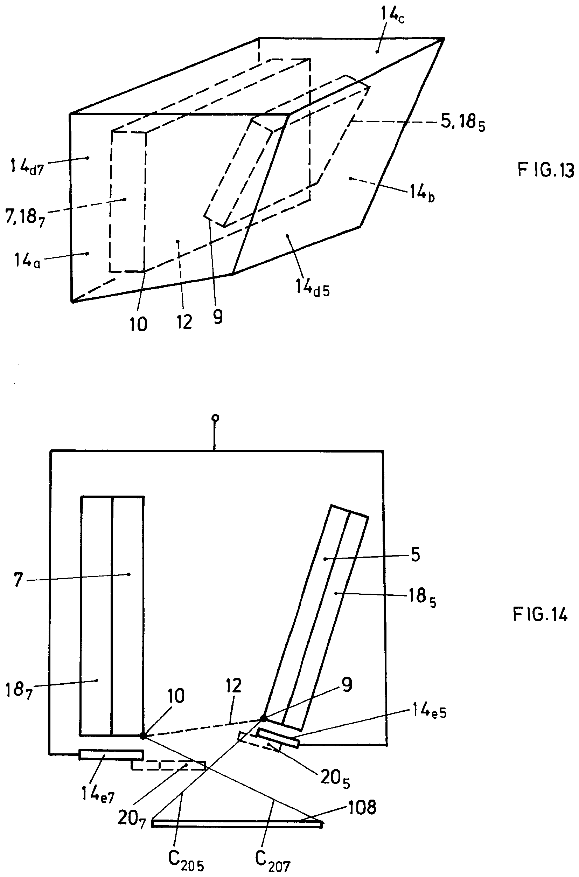

In the embodiment as shown schematically and simplified in fig. 13, the embodiments of figs. 11 and 12 are combined and complemented. The anode arrangement comprises, similar to a one side open box, the side plates $14_a$ and $14_b$, the top plate $14_c$, and further plates $14_{d5}$ and $14_{d7}$ extending behind the targets 5 and 7 and behind the respective magnet arrangements $18_{5,7}$. The catcher plate arrangements $20_{5,7}$ are not shown in fig. 13, for clearness sake.

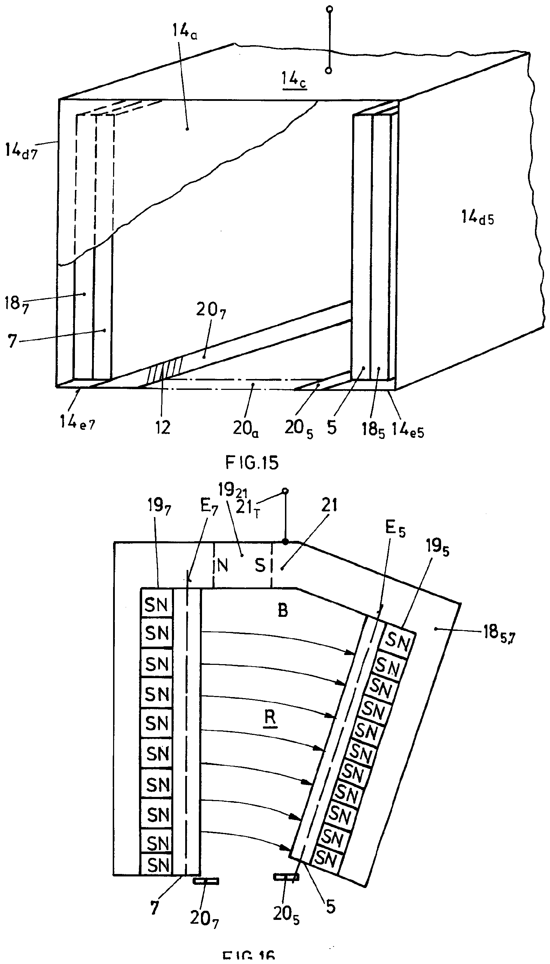

In a further embodiment of the sputtering source 1 as shown schematically and simplified by the side view of fig. 14, the anode arrangement comprises respective anode strips $14_{e7}$ and $14_{e5}$ which run exclusively along and distant from the rim portions 9 and 10. In this embodiment the catcher plate arrangements $20_{5,7}$ may be directly mounted to the anode strips $14_{e5}$ and $14_{e7}$ and are thereby, if made of metal, operated on the electric anode potential. Please note that anode strips frame like all around the borders of the targets are not provided. In one embodiment as shown schematically and simplified in the perspective view of the sputtering source 1 according to fig. 15, having equally square shaped targets 5 and 7, the embodiment of fig. 13 is combined with the embodiment of fig. 14. The catcher plate arrangements $20_{5,7}$ of metal are directly mounted to the anode strips $14_{e5}$ and $14_{e7}$. They may be of one piece with the anode strips.

As shown in fig. 15 in dash-dotted lines, the strip shaped catcher plate arrangements $20_{5,7}$ may be the legs of a catcher plate arrangement frame $20_a$. Such a catcher plate arrangement frame $20_a$ may be applied in all embodiments of the sputtering source 1. Thereby the four legs of such frame may be of equal or different materials. Each leg may comprise or consist of at least one metal plate, comprise or consist at least one ceramic material plate.

## 6. Magnetic field B and magnet arrangements $18_5$ and $18_7$

Different patterns of magnetic field B may be established in the reaction space R.

In one embodiment of the sputtering source 1 the magnetic field pattern has at least a part of the magnetic field unbalanced, impinging on or emanating from only one respective sputtering surface $S_5$ and/or $S_7$. Such unbalanced field components are addressed schematically in Fig. 1 at $B_{ub}$.

The magnetic field pattern may instead or additionally to unbalanced components, comprise components emanating at one sputtering surface and impinging at the second sputtering surface and also vice versa, thus being bi-directionally directed between the sputtering surfaces $S_{5,7}$ as schematically shown in Fig. 1 at B- and B+.

Further the magnetic field may comprise or consist of uni-directional field components, the magnetic field being exclusively directed from one specific sputtering surface e.g. from $S_5$ to the second sputtering surface, as of $S_7$.

The magnetic field pattern may even be tailored along at least one of the sputtering surfaces as a magnetron magnetic field, as perfectly known to the skilled artisan, such at least one target being then operated as a magnetron target (not shown).

Irrespective whether the magnetic field pattern consists or comprises unbalanced components and/or bi- directional components and/or uni-directional components and/or magnetron-type components, the magnetic field pattern may be swept or wobbled in the reaction space R by providing at least one of the magnet arrangements $18_{5,7}$ controllably moved with respect to the sputtering surfaces e.g. behind and along the sputtering surfaces $S_{5,7}$, as schematically shown in fig.1 by the double arrows P.

An embodiment of the sputtering source 1 at which the magnetic field pattern is uni-directional, exclusively from one sputtering surface $S_5$ to the other $S_7$, is

schematically and simplified shown in fig. 16. Such an embodiment has revealed, with respect to the pattern of magnetic field B in the reaction space R, as highly effective and of relatively simple realization.

Behind each of the targets 5,7 a two dimensional pattern of permanent magnets $19_5$ and $19_7$ is mounted. The magnet dipoles D (from N to S) are directed perpendicular to the respective plate-planes $E_5$ and $E_7$ and point at one target towards, at the other target from the sputtering surface $S_{5,7}$.

A magnet joke 21 of ferromagnetic material interconnects the two patterns $19_{5,7}$ along which additional permanent magnets may be provided as shown in dash line at $19_{21}$. The magnet joke may additionally be exploited to electrically supply the two targets 5 and 7 e.g. from a supply connection S.

## 7. Embodiment of the sputtering source 1 as realized today

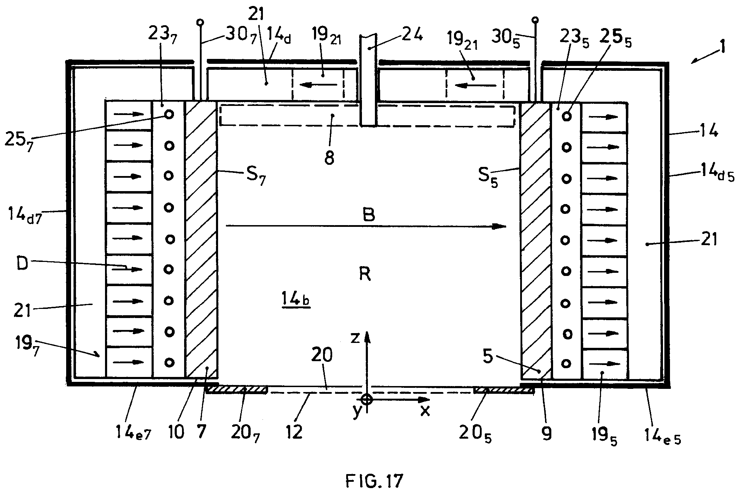

In Fig. 17 there is shown, schematically and simplified, a cross section through a sputtering source 1 as realized today. The same reference numbers are used for parts which have already been addressed.

In one embodiment the two plate-shaped targets 5 and 7 are equally shaped. They are square and parallel and the rim portions 9 and 10 are positioned in a plane. Opposite the sputtering surfaces $S_{5,7}$ each target 5,7 is in thermal contact with a respective cooling plate $23_{5,7}$ with cooling-medium lines $25_{5,7}$ for a liquid or gaseous cooling medium.

Opposite the targets 5, 7, with respect to the cooling plates $23_{5,7}$, the patterns of permanent magnets $19_{5,7}$ are provided with dipole directions as indicated at D. The patterns $19_{5,7}$ of permanent magnets are magnetically linked by the magnet joke 21. Additional permanent magnets $19_{21}$ may be provides along the magnet joke 21, as shown in dashed line in fig. 17.

With the exception of the open coating-material outlet area 12, restricted by the catcher plate arrangements $20_{5,7}$ the targets 5,7, the cooling plates and the magnet joke are surrounded by the anode arrangement 14 with the anode plates $14_{d5}$, $14_{d7}$, the top plate $14_c$, the lateral plates $14_b$, and $14_a$, as well as the anode strips $14es$ and $14_{e7}$. The catcher plate arrangements $20_{5,7}$ are mechanically and electrically connected to the anode strips $14es$ and $14e_7$.

Electric supply feed-troughs $30_5$, $30_7$ are provided through the magnet joke 21 and the anode plate 14c for electrically supplying the targets 5 and 7.

With the two feed-throughs $30_5$, $30_7$ both targets 5,7 may be electrically supplied independently from one another.

If both targets are to be equally electrically supplied, one single feed trough suffices and the magnetic joke may additionally be exploited as electrical feed line towards the targets. Further a gas feed line 24 for a working gas and /or oxygen discharges in the reaction space R.

The catcher plate arrangements $20_{5,7}$ may form the two legs of a frame 20 as has already been addressed in context with fig.15 and shown in fig.17 in dash line.

As schematically shown in Fig. 17 in dash line a third target 8 may be provided opposite the open coating-material outlet area 12. Providing such "cover" target 8 may be realized in all embodiments of the sputtering source 1.

## 8. Three target 5,7,8 sputtering source 1

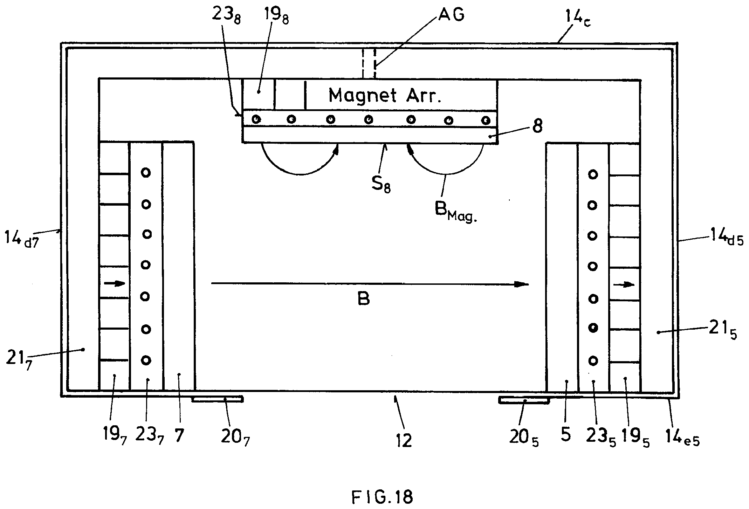

In fig. 18, schematically and simplified, an example is shown of a three-target embodiment of a sputtering source 1 according to the invention. The same reference numbers are used for same elements as up to now. There is provided opposite to the open coating-material outlet area 12 a third "covering" target 8 with sputtering surface $S_8$, cooling plate $23_8$ and pattern $19_8$ of permanent magnets. Thereby the third target 8 may be conceived as a magnetron with magnetron magnetic field $B_{mag}$.

In fig. 18 the electric- and gas- feed-troughs are not shown. In fig. 18, the two parts $21_5$ and $21_7$ of the magnet joke 21 may be separated by an air gap AG.

## 9. Sputtering chamber 100 in different embodiments

### 9.1 Single source/ single substrate chamber

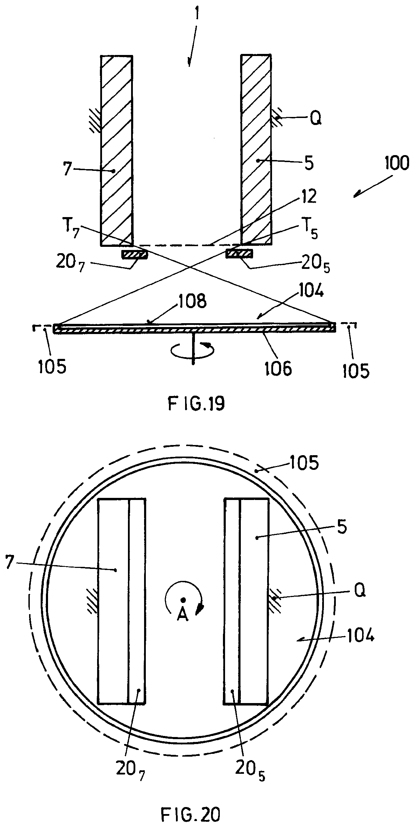

Figs. 19 and 20 show a single sputtering source 1/single substrate 104 sputtering chamber 100. Thereby, only the mutual arrangement of the targets 5 and 7, of the catcher plate arrangement $20_5$ and $20_7$ and of the substrate 104 are shown. As shown in fig. 19, at least the predominant part of the extended surface 108 of the circular substrate 104 is bared with respect to visibility to the respective transition surface areas $T_{5,7}$. This predominant part may be the complete extended surface area 108 of the substrate 104. Nevertheless it may be that some boarder areas 105, as shown in figs. 19 and 20 in dashed lines, may still be exposed to the addressed transition surface areas, under the consideration of low probability that high energy particles will impinge on such outermost peripheral areas 105 of the substrate 104.

In this embodiment the sputtering source 1 is exemplified having equally shaped, rectangular targets 5 and 7. The open coating-material outlet area 12 extends along a plane parallel to the holder plane along which the substrate 104 is held on the substrate holder 106. The open coating -material outlet area 12 is centralized with respect to the central axis A of the substrate 104 and of the substrate holder 106 and faces the extended surface 108 of the substrate 104 and thus the substrate holder 106. The substrate 104 is rotated by a drive (not shown in figs. 19, 20) rotating the substrate holder 106 about the central axis A. The targets 5 and 7 are stationary as schematically shown at Q.

### 9.2 Multiple source / single substrate chamber 100

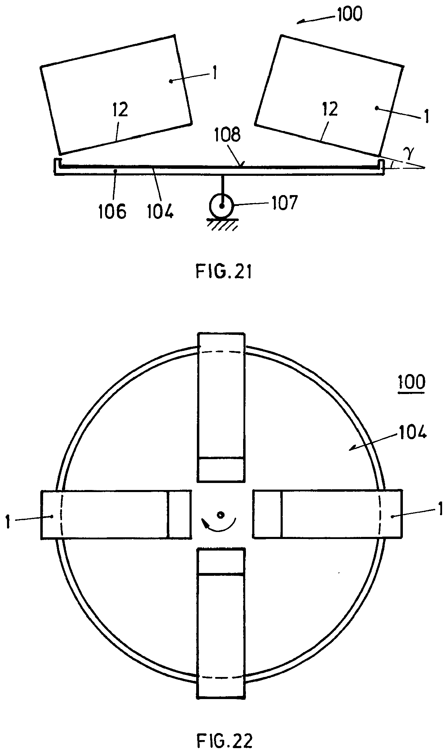

Both figs. 21 and 22 show schematically and most simplified a side-view and a top-view on a four-source 1, single substrate 104 sputtering chamber 100. In this embodiment the open coating-material outlet areas 12 of the sputtering sources 1 are inclined by an angle $\gamma$ with respect to the plane along which the substrate 104 is supported on the substrate holder 106. Thereby, and with an inclination angle

$$0° \leq \gamma \leq 45°$$

the coating thickness homogeneity along the extended surface 108 of the substrate 104 is improved. Again and as schematically shown by drive 107, the substrate holder 106 may be rotated about its central axis A and therewith the substrate 104.

Clearly, less than four or more than four sources 1 may be provided to commonly sputter-coat the surface 108 of the one substrate 104 with one or more than one oxide layers.

### 9.3 Batch sputter chamber 100

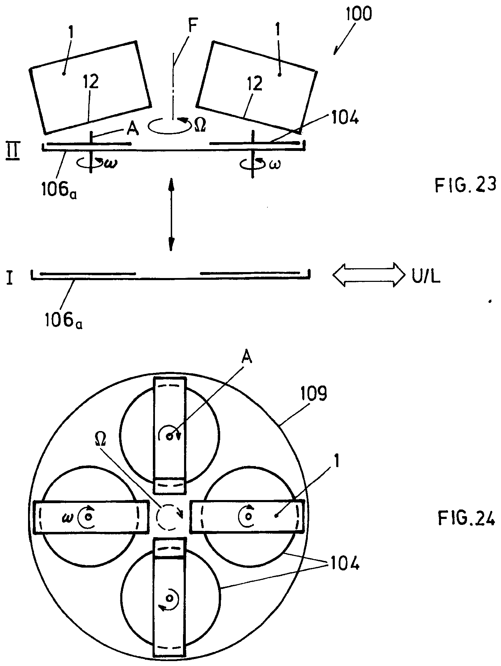

Figs. 23 and 24 show in a representation in analogy to those of the figs. 21 and 22 a four-sputtering source 1/four-substrate 104 batch sputtering chamber 100. The four substrates 104 are first loaded on a multiple substrate holder carrier $106_a$ in a loading/unloading positon I, as shown by the load/unload double-arrow U/L. Together with the multiple-substrate holder carrier $106_a$ the batch of substrates 104 is lifted in coating position II within sputtering chamber 100. There, different possibilities are operational:

a) Each substrate 104 is aligned with one of the sputtering sources 1 and is there rotated about its central axis A as shown at $\omega$. Thus, in fact, each substrate of the batch is treated as a single substrate according to figs. 19 and 20. Once the batch of substrates 104 is coated, the multiple substrate holder carrier $106_a$ is moved downwards from coating position II in loading/unloading position I.

b) The multiple substrate holder carrier $106_a$ is as well rotated about its central F axis as shown at $\Omega$ by which the homogeneity of the thickness of the deposited oxide layer on the substrates 104 may be improved.

c) Rotation $\omega$ of the substrates 104 is avoided by replacing the one source 1 at the coating position of the substrates 104 by multiple sputtering source (not shown).

Nevertheless, as all substrates 104 are simultaneously treated, the respective sputtering chamber of this embodiment is a batch sputtering chamber.

Clearly, the embodiment according to figs. 23 and 24 may be realized in variants for batches of less or of more than four substrates 104 and with more or less than four sputtering sources 1.

### 9.4 In-line sputter chamber 100

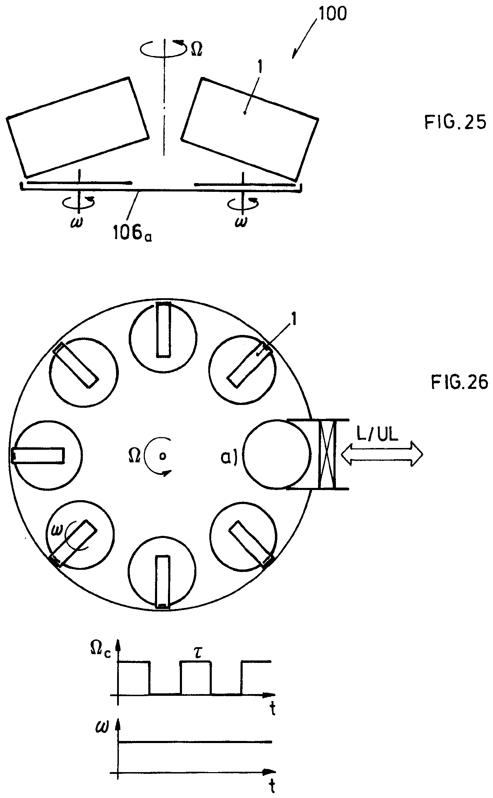

Figs. 25 and 26 show in a representation in analogy to those of the figs. 23 and 24 a sputtering chamber 100 conceived as an inline sputtering chamber. There are provided seven sputtering sources 1 distributed along a circle. The multiple substrate holder carrier $106_a$ is constructed to hold eight circular substrates 104 on respective substrate holders evenly distributed along its periphery. In a first position (a) of the multiple substrate holder carrier $106_a$ and as schematically shown in fig. 26, substrates are unloaded and loaded from / to one of the substrate holders 106 on the carrier $106_a$. Loading and unloading operation lasting $0.5\tau$ each. If $\tau$ is the in-line clock period, in one clock period one substrate holder 106 is unloaded and reloaded.

With the clock period $\tau$ the multiple substrate holder carrier $106_a$ is rotated according to $\Omega$ stepwise so that each substrate 104, once loaded in position (a), is stepped seven times to sputter coating subsequently by the seven sputtering sources 1. Once a substrate has passed the seven sputtering sources 1 it is unloaded in position (a) and an uncoated substrate is loaded. Taken the case where all the seven sputtering sources 1 coat the substrates 104 with an equally thick oxide layer, then the substrates are finally coated with an oxide layer of 7x the thickness deposited by each of the sputtering sources 1. The throughput has nevertheless the rate $1/\tau$. Sputter coating one substrate by one sputtering source with same thickness would necessitate a sputtering time of $7\tau$. The throughput rate would be $1/7\tau$. Thus, by using such an inline sputtering chamber 100, the time duration of the overall sputter coating process may be tailored largely independently from the step- rate of the inlying machine.

Here too rotation $\omega$ of the substrate may be avoided by replacing the single sputtering sources 1 at the coating positions of the substrates 104 by multiple sputtering sources commonly coating a respective substrate.

### 10. Electric feed of the sputter chamber 100

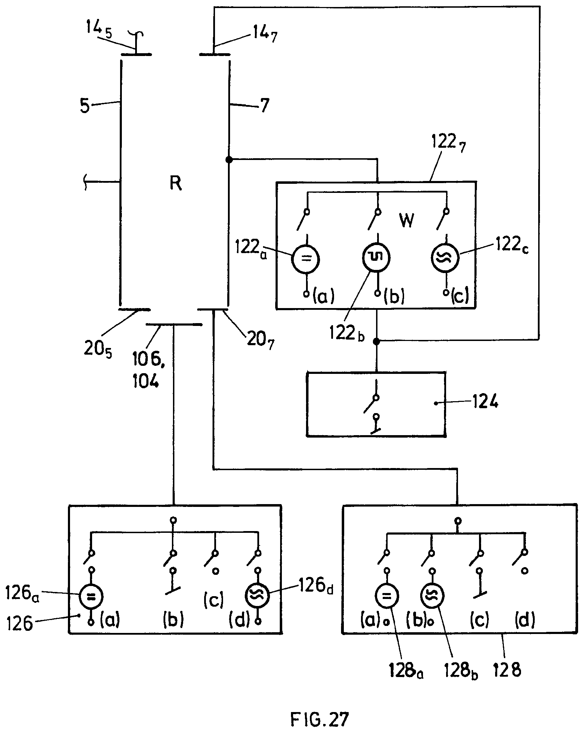

In Fig. 27 there is most schematically shown the two targets 5 and 7 of the sputtering source 1, the substrate holder 104 of the sputter chamber 100 with substrate 106, the catcher plate arrangements $20_5$ and $20_7$ and the target-specific anode arrangements $14_7$ and $14_5$. In block $122_7$ the different possibilities of electrically supplying the target 7 with respect to the specific anode arrangement $14_7$ is schematically represented by the possibility selecting switches W which represents the possibilities to supply the target 7 with respect to the anode arrangement $14_7$ in at least one of the manners (a), (b), (c).

In option or manner (a) the target 7 /anode arrangement $14_7$ is electrically supplied by a DC supply source $122_a$. According to option (b) the target 7 is operated with respect to the anode arrangement $14_7$ by a pulsed DC source $122_b$.

According to option (c) the target 7 is operated with respect to the anode arrangement $14_7$ by a RF supply source $122_c$. Two or three of the supplies may be combined, e.g. DC with pulsed DC, Pulsed DC with RF etc. Thereby and as schematically represented by the option block 124 the addressed supply sources $122_a$ to $122_c$ may be operated in a floating manner or with respect to a reference potential, e.g. the anode potential being ground potential.

The second target 5 may be electrically supplied with respect to the anode arrangement $14_5$ with the same possibilities or options as just addressed for electrically supplying the target 7 with respect to the anode arrangement $14_7$. Target 5 may also be directly connected over the joke or an electrical connection with the target 7. Therefore, in Fig. 27, the respective possibilities for electrically supplying target 5 with respect to anode arrangement $14_5$ are not shown.

The two targets 5 and 7 may be electrically supplied separately by different supply possibilities (a) to (c) and in a floating manner or referred to a reference potential or the two targets/anodes may be electrically supplied equally, i.e. according to option (a) and/or (b) and/or (c) floatingly or referred to a reference potential. Then the two anode arrangements $14_5$ and $14_7$ may be combined to one anode arrangement 14 and the two targets 5 and 7 may both be operated by a common electric supply.

In todays' embodiment which was addressed above, the two targets 5 and 7 are both operated by a common DC and RF supply source with respect to a common anode arrangement 14. Thereby the anode is operated at ground reference potential.

Fig. 27 shows further in block 126 and in a representation in analogy to that which was used to explain the possibilities of electrically supplying the targets 5 and 7 with respect to the anode arrangement, four options (a) to (d) for operating the substrate holder 104 and the substrate 106 deposited and held on the support 106.

According to a first option or manner, the substrate holder 104 and thus the substrate 106 are biased by a DC-bias source $126_a$. According to a second option (b) the substrate 106 and thus the substrate holder 104 is operated on electric ground potential. According to a further option (c) the substrate 106 is operated in an electrically floating manner. The substrate 104 is either held on the substrate support 106 in an electrically isolated manner or at least the directly supporting part of support 104 is operated in a floated manner, i.e. is electrically isolated from other parts of the sputtering chamber 100 which are on electric potentials.

According to option (d) the substrate holder 104 and thus the substrate 106 is biased by means of a RF-biasing source $126_d$. In today's practiced embodiment which was already addressed above the substrate 106 is operated in an electrically floating manner or on ground potential.

In block 128 of Fig. 27 the options (a), (b), (c), (d) are addressed for electrically supplying those parts of the catcher plate arrangements $20_{5,7}$ which are of metal. According to option (a) these parts of the catcher plate arrangements may be electrically supplied by a DC supply source $128_a$. According to a second option (b) the addressed metal parts of the catcher plate arrangements $20_{5,7}$ are electrically supplied by an RF supply source $128_b$. According to option (c) the addressed parts are operated at ground potential and according to option (d) they are operated in an electrically floating manner.

Please note that if the one or both catcher plate arrangements comprise mutually isolated metal plates, and according to specific needs, such plates may electrically supplied differently as e.g. on different electric DC potentials. According to the today realized embodiment and as was addressed, each catcher plate arrangement $20_{5,7}$ is made of a metal plate and electrically operated on anode potential.

Making use of the sputtering source according to the invention it was possible to drastically reduce damage impacts on the manufactured, oxide coated substrates, the substrate the coating interface and the oxide coating.

**Claims**

1. A sputtering source (1) conceived to sputter coat a substrate (104) comprising:

   • two plate shaped targets (5, 7) extending along respective plate-planes ($E_5$, $E_7$), the sputtering surfaces ($S_5$, $S_7$) of said targets (5, 7) facing each other thereby defining, in between, a reaction space (R), said plate-planes ($E_5$, $E_7$) being mutually parallel or mutually inclined by at most 90°;
   • an anode arrangement (14, $14_5$, $14_7$);
   • a magnet arrangement ($18_5$, $18_7$) along each of said targets (5, 7) and opposite to the respective sputtering surfaces ($S_5$, $S_7$), each magnet arrangement ($18_5$, $18_7$) generating a magnetic field in said reaction space (R) impinging on and/ or emanating from and distributed along at least a predominant part of the respective sputtering surfaces ($S_5$, $S_7$);
   • an open coating outlet area (12) from said reaction space (R) to a coating space (S), limited by respective areas of mutually facing rims (9, 10) of said two plate shaped targets (5, 7);
   • said sputtering surfaces ($S_5$, $S_7$) of said targets (5, 7) transiting into respective side surface areas ($L_5$, $L_7$) of said targets (5, 7) along said mutually facing rims (9, 10) by respective transition surface ($T_5$, $T_7$) areas of said targets (5, 7), said transition surface ($T_5$, $T_7$) areas having a smaller radius of curvature than the adjacent areas of the respective sputtering surface ($S_5$, $S_7$);
   • a projecting catcher plate arrangement ($20_5$, $20_7$) along each of said rims (9, 10) and distant from the respective one of said targets (5, 7) and respectively projecting in a direction from said rims (9, 10) towards each other into said open coating outlet area (12), thereby restricting said open coating outlet area (12) as limited by said mutually facing rims (9, 10) of said two plate shaped targets (5, 7),
   **characterized by** the fact that
   • said projecting catcher plate arrangement ($20_5$, $20_7$) has an overall surface which predominantly consists of a first extended surface area and of an opposite second extended surface area, said first extended surface area being exclusively exposed to said reaction space (R) whereas said second extended surface area being exclusively exposed to said coating space (S).

2. The sputtering source of claim 1 constructed to sputter coat said substrate (104) with a material at least one component thereof being present in the sputtering plasma as a ion.

3. The sputtering source of one of claims 1 or 2 constructed to sputter coat said substrate (104) with a material at least one component thereof being present in the sputtering plasma as a negative ion.

4. The sputtering source of one of claims 1 to 3 constructed to sputter coat said substrate (104) with an oxide.

5. The sputtering source of at least one of claims 1 or 4 wherein each catcher plate arrangement ($20_5$, $20_7$) has a most projecting rim and a distance from said most projecting rim to a side surface of the respective target (5, 7), measured in a plane parallel to the respective plate plane and perpendicularly to the length extent of said most projecting rim, is smaller than a distance between said most projecting rim and a surface of the respective target (5, 7), measured in a plane perpendicular to said respective plate plane and perpendicular to said length extent of said most projecting rim.

6. The sputtering source of at least one of claims 1 to 5 said plate-planes ($E_5$, $E_7$) being symmetrical to a central plane.

7. The sputtering source of at least one of claims 1 to 6 said plate-planes ($E_5$, $E_7$) being parallel.

8. The sputtering source of at least one of claims 1 to 7 wherein said mutually facing rims (9, 10) are linear and parallel.

9. The sputtering source of at least one of claims 1 to 8 wherein said plate shaped targets (5, 7) are rectangular or square.

10. The sputtering source of at least one of claims 1 to 9 said plate-planes ($E_5$, $E_7$) being symmetrical to a central plane, said open coating outlet area (12) extending along a plane perpendicular to said central plane.

11. The sputtering source of at least one of claims 1 to 10 at least one of the targets (5, 7) being of a single material.

12. The sputtering source of at least one of claims 1 to 11 at least one of said targets (5, 7) comprising an oxide or consisting of an oxide.

13. The sputtering source of at least one of claims 1 to 12 at least one of said targets (5, 7) comprising a material component being present in the sputtering plasma as a ion.

14. The sputtering source of at least one of claims 1 to 13 at least one of said targets (5, 7) comprising a material component being present in the sputtering plasma as a negative ion.

15. The sputtering source of at least one of claims 1 to 14 comprising an oxygen gas feed arrangement (102) discharging into said reaction space and/or downstream said restricted open coating outlet area, restricted by said catcher plate arrangement ($20_5$, $20_7$).

16. The sputtering source of at least one of claims 1 to 15 comprising a gas feed arrangement (102) discharging into said reaction space (R) and/or downstream said restricted open coating outlet area (12), restricted by said catcher plate arrangement ($20_5$, $20_7$).

17. The sputtering source of at least one of claims 1 to 16, said catcher plate arrangement ($20_5$, $20_7$) comprise catcher plates ($20_5$, $20_7$) of at least one of the following shapes: plane, bent towards said reaction space, bent away from said reaction space (R).

18. The sputtering source of at least one of claims 1 to 17 wherein at least one of said catcher plate arrangement ($20_5$, 207) comprises at least one metal plate or consists of at least one metal plate.

19. The sputtering source of at least one of claims 1 to 18 wherein at least one of said catcher plate arrangement ($20_5$, 207) comprises at least one ceramic material plate or consists of at least one ceramic material plate.

20. The sputtering source of at least one of claims 1 to 19, said anode arrangement (14) comprising a lateral anode plate, complementing the two-side delimitation of said reaction space (R) by said two targets (5, 7) to a three-side delimitation of said reaction space (R).

21. The sputtering source of claim 20 comprising two of said lateral anode plates complementing the two-side delimitation of said reaction space by said two targets (5, 7) to a four-side delimitation of said reaction space.

22. The sputtering source of at least one of claims 1 to 21 said anode arrangement (14) comprising a lateral anode plate, complementing the two-side delimitation of said open coating outlet area (12) by said two targets (5, 7) to a three-side delimitation of said open coating outlet area (12).

23. The sputtering source of claim 22 said anode arrangement (14) comprising two of said lateral anode plates, complementing the two-side delimitation of said open coating outlet area (12) by said two targets (5, 7) to a four-side delimitation of said open coating outlet area (12).

24. The sputtering source of at least one of claims 1 to 23, said anode arrangement (14) comprising an anode plate opposite to said open coating outlet area (12) with respect to said reaction space (R).

25. The sputtering source of at least one of claims 1 to 24, said anode arrangement (14) comprising an anode frame around said open coating outlet area (12).

26. The sputtering source of at least one of claims 1 to 25 said anode arrangement (14) comprising an arrangement of anode strips along the border of said targets (5, 7) and exclusively along said mutually facing rims (9, 10).

27. The sputtering source of at least one of claims 1 to 26, said anode arrangement (14) comprising an arrangement of anode strips along said mutually facing rims (9, 10), said catcher plate arrangement ($20_5$, $20_7$) comprising projecting metal plates electrically and mechanically connected to said anode strips.

28. The sputtering source of at least one of claims 1 to 27 said catcher plate arrangement ($20_5$, $20_7$) comprising projecting metal plates electrically connected to said anode arrangement (14) .

29. The sputtering source of at least one of claims 1 to 28 said catcher plate arrangement ($20_5$, $20_7$) being two legs of a frame limiting and around said open coating outlet area (12).

30. The sputtering source of at least one of claims 1 to 29 said magnetic field being generated uni-directionally from one sputtering surface ($S_5$) to the other sputtering surface ($S_7$).

31. The sputtering source of at least one of claims 1 to 30 comprising a third target (8) covering said reaction space (r) opposite said open coating outlet area (12).

32. The sputtering source of claim 31 said third target (8) being associated with a magnet arrangement ($19_8$) generating along the sputter surface of said third target (8) a magnetron magnetic field.

33. The sputtering source of at least one of claims 1 to 32 at least one of said targets (5, 7, 8) comprising or consisting of at least one of the metals In, Sn, Zn, Ga, Al.

34. The sputtering source of at least one of claims 1 to 33 at least one of said targets (5, 7, 8) comprising a material component which is present in the sputtering plasma as a ion.

35. The sputtering source of at least one of claims 1 to 34 at least one of said targets (5, 7, 8) comprising a material component which is present in the sputtering plasma as a negative ion.

36. The sputtering source of at least one of claims 1 to 35 at least one of said targets (5, 7, 8) comprising or consisting of an oxide.

37. The sputtering source according at least one of claims 1 to 36, wherein said plate-planes ($E_5$, $E_7$) are mutually inclined by at most 5°.

38. A sputter coating chamber (100) comprising at least one sputtering source (1) according to at least one of claims 1 to 37 and further comprising a substrate holder (106) constructed to hold a substrate (104) with one of its extended surfaces exposed to said coating space (S), said substrate holder (106) being mounted in said sputter coating chamber (100) in a position in which said extended surface faces said restricted open coating outlet area (12) and visibility of said transition surface areas from at least a predominant part of said extended surface is bared by said catcher plate arrangement ($20_5$, $20_7$).

39. The sputter coating chamber of claim 38, wherein said substrate holder (106) is constructed to hold a substrate (104) along a holding-plane, said mutually facing rims (9, 10) are parallel and linear and said holding-plane is parallel to or is inclined with respect to a plane defined by said parallel and linear rims (9, 10).

40. The sputter coating chamber of claim 39, wherein said holding- plane and said plane defined by said rims (9, 10) are inclined by at most 45°.

41. The sputter coating chamber of at least one of claims 38 to 40, wherein said substrate (104) on said substrate holder (106) is operated in an electrically floating manner or is connectable to a DC reference potential, preferably to ground potential.

42. The sputter coating chamber of at least one of claims 38 to 41 said substrate holder (106) being constructed to hold a circular substrate (104) and is operationally connected a rotary drive, rotating said substrate holder (106) about a central axis.

43. The sputter coating chamber of at least one of claims 38 to 42, comprising a substrate-holder-carrier with at least two of said substrate holders, the number of said sputtering sources provided being equal or different from the number of said at least two substrate holders on said carrier.

44. A sputtering system comprising at least one sputter source according to at least one of claims 1 to 37 or at least one sputter chamber according to at least one of claims 38 to 43, further comprising a gas feed arrangement (102) delivering a gas into the reaction space of said at least one sputtering source, and /or between the open coating material outlet area of said sputtering source and said substrate holder.

45. The system of claim 44 wherein said gas feed arrangement (102) is in operational flow connection with a gas reservoir arrangement containing a gas, said gas or at least one component thereof being present in the sputtering plasma as a ion.

46. The system of at least one of claims 44 or 45 wherein said gas feed arrangement (102) is in operational flow connection with a gas reservoir arrangement containing a gas, said gas or at least one component thereof being present in the sputtering plasma as a negative ion.

47. The system of at least one of claims 44 to 46 wherein said gas feed arrangement (102) is in operational flow connection with a gas reservoir arrangement containing a gas, said gas or at least one component thereof being oxygen.

**48.** The sputtering system of at least one of claims 44 to 47, at least one of said targets (5, 7, 8) being electrically supplied by at least one supply source generating at least one of DC, pulsed DC, RF.

**49.** A method of sputter coating a substrate with a material, at least one component thereof being present in the sputtering plasma as a ion, or of manufacturing substrate coated with said material, the methods comprising applying said coating by means of at least one sputtering source according to at least one of claims 1 to 37 or by means of a sputter chamber according to at least one of claims 38 to 43 or by means of a system according to at least one of claims 44 to 48.

**50.** The method of claim 49 thereby coating said substrate with a material, at least one component thereof being present in the sputtering plasma as a negative ion.

**51.** The method of at least one of claims 49 or 50 thereby coating said substrate with an oxide.

**52.** The method according to at least one of claims 49 to 51 comprising blocking by said catcher plate arrangement ($20_5$, $20_7$) of said sputtering source ions having an energy of at least 0.5 UAC $\times$ e- from impinging on said substrate, wherein UAC is the time-average of the absolute value of the anode/target voltage.


**Patentansprüche**

**1.** Sputterquelle (1), die zur Sputterbeschichtung eines Substrats (104) konzipiert ist, umfassend:

• zwei plattenförmige Targets (5, 7), die sich entlang jeweiliger Plattenebenen ($E_5$, $E_7$) erstrecken, wobei die Sputterflächen ($S_5$, $S_7$) der Targets (5, 7) einander zugewandt sind, wodurch dazwischen ein Reaktionsraum (R) definiert wird, wobei die Plattenebenen ($E_5$, $E_7$) zueinander parallel oder zueinander um höchstens 90° geneigt sind;
• eine Anodenanordnung (14, $14_5$, $14_7$);
• eine Magnetanordnung ($18_5$, $18_7$) entlang von jedem der Targets (5, 7) und gegenüber den jeweiligen Sputterflächen ($S_5$, $S_7$), wobei jede Magnetanordnung ($18_5$, $18_7$) ein Magnetfeld in dem Reaktionsraum (R) generiert, das auf der jeweiligen Sputterflächen ($S_5$, $S_7$) auftrifft und/oder davon ausgeht und entlang mindestens eines überwiegenden Teils der jeweiligen Sputterflächen ($S_5$, $S_7$) verteilt ist;
• einen offenen Beschichtungsauslassbereich (12) von dem Reaktionsraum (R) zu einem Beschichtungsraum (S), der durch jeweilige Bereiche voneinander zugewandten Kanten (9, 10) der zwei plattenförmigen Targets (5, 7) begrenzt ist;
• die Sputterflächen ($S_5$, $S_7$) der Targets (5, 7), die in jeweilige Seitenflächenbereiche ($L_5$, $L_7$) der Targets (5, 7) entlang der einander zugewandten Kanten (9, 10) durch jeweilige Bereiche einer Übergangsfläche ($T_5$, $T_7$) der Targets (5, 7) übergehen, wobei die Bereiche der Übergangsfläche ($T_5$, $T_7$) einen kleineren Krümmungsradius aufweisen als die angrenzenden Bereiche der jeweiligen Sputterfläche ($S_5$, $S_7$);
• eine herausragende Fangplattenanordnung ($20_5$, $20_7$) entlang jeder der Kanten (9, 10) und entfernt von dem jeweils einen der Targets (5, 7) und jeweils in einer Richtung von den Kanten (9, 10) weg und zueinander hin in den offenen Beschichtungsauslassbereich (12) herausragend, wodurch der offene Beschichtungsauslassbereich (12) eingeschränkt wird, der durch die einander zugewandten Kanten (9, 10) der zwei plattenförmigen Targets (5, 7) begrenzt wird, , **gekennzeichnet durch** die Tatsache, dass:
• die herausragende Fangplattenanordnung ($20_5$, $20_7$) eine Gesamtfläche aufweist, die überwiegend aus einer ersten erweiterten Oberfläche und aus einer gegenüberliegenden zweiten erweiterten Oberfläche besteht, wobei die erste erweiterte Oberfläche ausschließlich zum Reaktionsraum (R) hin exponiert ist, wohingegen die zweite erweiterte Oberfläche ausschließlich zum Beschichtungsraum (S) hin exponiert ist.

**2.** Sputterquelle nach Anspruch 1, die konstruiert ist, um eine Sputterbeschichtung des Substrats (104) mit einem Material durchzuführen, wobei mindestens eine Komponente davon in dem Sputterplasma als ein Ion vorliegt.

**3.** Sputterquelle nach einem der Ansprüche 1 oder 2, die konstruiert ist, um eine Sputterbeschichtung des Substrats (104) mit einem Material durchzuführen, wobei mindestens eine Komponente davon in dem Sputterplasma als ein negatives Ion vorliegt.

**4.** Sputterquelle nach einem der Ansprüche 1 bis 3, die konstruiert ist, um eine Sputterbeschichtung des Substrats (104) mit einem Oxid durchzuführen.

**5.** Sputterquelle nach mindestens einem der Ansprüche 1 oder 4, wobei jede Fangplattenanordnung ($20_5$, $20_7$) eine am stärksten herausragende Kante aufweist und ein Abstand von der am stärksten herausragenden Kante zu einer Seitenfläche des jeweiligen Targets (5, 7), gemessen in einer Ebene parallel zu der jeweiligen Plattenebene und senkrecht zu der Längenausdehnung der am stärksten herausragenden Kante, kleiner ist als ein Abstand zwischen der am stärksten herausragenden Kante und einer Fläche des jeweiligen Targets (5, 7), gemessen in einer Ebene senkrecht zu der jeweiligen Plattenebene und senkrecht zu der Längenausdehnung der am stärksten herausragenden Kante.

6. Sputterquelle nach mindestens einem der Ansprüche 1 bis 5, wobei die Plattenebenen ($E_5$, $E_7$) zu einer mittleren Ebene symmetrisch sind.

7. Sputterquelle nach mindestens einem der Ansprüche 1 bis 6, wobei die Plattenebenen ($E_5$, $E_7$) parallel sind.

8. Sputterquelle nach mindestens einem der Ansprüche 1 bis 7, wobei die einander zugewandten Kanten (9, 10) linear und parallel sind.

9. Sputterquelle nach mindestens einem der Ansprüche 1 bis 8, wobei die plattenförmigen Targets (5, 7) rechteckig oder quadratisch sind.

10. Sputterquelle nach mindestens einem der Ansprüche 1 bis 9, wobei die Plattenebenen ($E_5$, $E_7$) zu einer mittleren Ebene symmetrisch sind, wobei sich der offene Beschichtungsauslassbereich (12) entlang einer Ebene senkrecht zu der mittleren Ebene erstreckt.

11. Sputterquelle nach mindestens einem der Ansprüche 1 bis 10, wobei mindestens eines der Targets (5, 7) aus einem einzigen Material besteht.

12. Sputterquelle nach mindestens einem der Ansprüche 1 bis 11, wobei mindestens eines der Targets (5, 7) ein Oxid umfasst oder aus einem Oxid besteht.

13. Sputterquelle nach mindestens einem der Ansprüche 1 bis 12, wobei mindestens eines der Targets (5, 7) eine Materialkomponente umfasst, die in dem Sputterplasma als ein Ion vorliegt.

14. Sputterquelle nach mindestens einem der Ansprüche 1 bis 13, wobei mindestens eines der Targets (5, 7) eine Materialkomponente umfasst, die in dem Sputterplasma als ein negatives Ion vorliegt.

15. Sputterquelle nach mindestens einem der Ansprüche 1 bis 14, umfassend eine Sauerstoffgaszufuhranordnung (102), die sich in den Reaktionsraum und/oder nach dem eingeschränkten offenen Beschichtungsauslassbereich entlädt, der durch die Fangplattenanordnung ($20_5$, $20_7$) eingeschränkt ist.

16. Sputterquelle nach mindestens einem der Ansprüche 1 bis 15, umfassend eine Gaszufuhranordnung (102), die sich in den Reaktionsraum (R) und/oder nach dem eingeschränkten offenen Beschichtungsauslassbereich (12) entlädt, der durch die Fangplattenanordnung ($20_5$, $20_7$) eingeschränkt ist.

17. Sputterquelle nach mindestens einem der Ansprüche 1 bis 16, wobei die Fangplattenanordnung ($20_5$, $20_7$) Fangplatten ($20_5$, $20_7$) mit mindestens einer der folgenden Formen umfasst: eben, zu dem Reaktionsraum gebogen, von dem Reaktionsraum (R) weggebogen.

18. Sputterquelle nach mindestens einem der Ansprüche 1 bis 17, wobei mindestens eine der Fangplattenanordnung ($20_5$, $20_7$) mindestens eine Metallplatte umfasst oder aus mindestens einer Metallplatte besteht.

19. Sputterquelle nach mindestens einem der Ansprüche 1 bis 18, wobei mindestens eine der Fangplattenanordnung ($20_5$, $20_7$) mindestens eine Keramikmaterialplatte umfasst oder aus mindestens einer Keramikmaterialplatte besteht.

20. Sputterquelle nach mindestens einem der Ansprüche 1 bis 19, wobei die Anodenanordnung (14) eine seitliche Anodenplatte umfasst, welche die zweiseitige Begrenzung des Reaktionsraums (R) durch die zwei Targets (5, 7) zu einer dreiseitigen Begrenzung des Reaktionsraums (R) ergänzt.

21. Sputterquelle nach Anspruch 20, umfassend zwei der seitlichen Anodenplatten, welche die zweiseitige Begrenzung des Reaktionsraums durch die zwei Targets (5, 7) zu einer vierseitigen Begrenzung des Reaktionsraums ergänzen.

22. Sputterquelle nach mindestens einem der Ansprüche 1 bis 21, wobei die Anodenanordnung (14) eine seitliche Anodenplatte umfasst, welche die zweiseitige Begrenzung des offenen Beschichtungsauslassbereichs (12) durch die zwei Targets (5, 7) zu einer dreiseitigen Begrenzung des offenen Beschichtungsauslassbereichs (12) ergänzt.

23. Sputterquelle nach Anspruch 22, wobei die Anodenanordnung (14) zwei der seitlichen Anodenplatten umfasst, welche die zweiseitige Begrenzung des offenen Beschichtungsauslassbereichs (12) durch die zwei Targets (5, 7) zu einer vierseitigen Begrenzung des offenen Beschichtungsauslassbereichs (12) ergänzen.

24. Sputterquelle nach mindestens einem der Ansprüche 1 bis 23, wobei die Anodenanordnung (14) eine Anodenplatte gegenüber dem offenen Beschichtungsauslassbereich (12) in Bezug auf den Reaktionsraum (R) umfasst.

25. Sputterquelle nach mindestens einem der Ansprüche 1 bis 24, wobei die Anodenanordnung (14) einen Anodenrahmen um den offenen Beschichtungsauslassbereich (12) umfasst.

26. Sputterquelle nach mindestens einem der Ansprüche 1 bis 25, wobei die Anodenanordnung (14) eine Anordnung von Anodenstreifen entlang der Grenze der Targets (5, 7) und ausschließlich entlang der einander zugewandten Kanten (9, 10) umfasst.

27. Sputterquelle nach mindestens einem der Ansprüche 1 bis 26, wobei die Anodenanordnung (14) eine Anordnung von Anodenstreifen entlang der einander zugewandten Kanten (9, 10) umfasst, wobei die Fangplattenanordnung ($20_5$, $20_7$) herausragende Metallplatten umfasst, die elektrisch und mechanisch mit den Anodenstreifen verbunden sind.

28. Sputterquelle nach mindestens einem der Ansprüche 1 bis 27, wobei die Fangplattenanordnung ($20_5$, $20_7$) herausragende Metallplatten umfasst, die elektrisch mit der Anodenanordnung (14) verbunden sind.

29. Sputterquelle nach mindestens einem der Ansprüche 1 bis 28, wobei die Fangplattenanordnung ($20_5$, $20_7$) zwei Schenkeln eines Rahmens entspricht, der den offenen Beschichtungsauslassbereich (12) begrenzt und sich um diesen herum befindet.

30. Sputterquelle nach mindestens einem der Ansprüche 1 bis 29, wobei das Magnetfeld unidirektional von einer Sputterfläche ($S_5$) zu der anderen Sputterfläche ($S_7$) generiert wird.

31. Sputterquelle nach mindestens einem der Ansprüche 1 bis 30, umfassend ein drittes Target (8), das den Reaktionsraum (r) gegenüber dem offenen Beschichtungsauslassbereich (12) bedeckt.

32. Sputterquelle nach Anspruch 31, wobei das dritte Target (8) mit einer Magnetanordnung (19s) verknüpft ist, die entlang der Sputterfläche des dritten Targets (8) ein Magnetron-Magnetfeld generiert.

33. Sputterquelle nach mindestens einem der Ansprüche 1 bis 32, wobei mindestens eines der Targets (5, 7, 8) mindestens eines der Metalle In, Sn, Zn, Ga, Al umfasst oder daraus besteht.

34. Sputterquelle nach mindestens einem der Ansprüche 1 bis 33, wobei mindestens eines der Targets (5, 7, 8) eine Materialkomponente umfasst, die in dem Sputterplasma als ein Ion vorliegt.

35. Sputterquelle nach mindestens einem der Ansprüche 1 bis 34, wobei mindestens eines der Targets (5, 7, 8) eine Materialkomponente umfasst, die in dem Sputterplasma als ein negatives Ion vorliegt.

36. Sputterquelle nach mindestens einem der Ansprüche 1 bis 35, wobei mindestens eines der Targets (5, 7, 8) ein Oxid umfasst oder daraus besteht.

37. Sputterquelle nach mindestens einem der Ansprüche 1 bis 36, wobei die Plattenebenen ($E_5$, $E_7$) zueinander um höchstens 5° geneigt sind.

38. Sputterbeschichtungskammer (100), umfassend mindestens eine Sputterquelle (1) nach mindestens einem der Ansprüche 1 bis 37 und ferner umfassend einen Substrathalter (106), der konstruiert ist, um ein Substrat (104) mit einer seiner erweiterten Flächen zu halten, die gegenüber dem Beschichtungsraum (S) exponiert sind, wobei der Substrathalter (106) in der Sputterbeschichtungskammer (100) in einer Position montiert ist, in der die erweiterte Fläche dem eingeschränkten offenen Beschichtungsauslassbereich (12) zugewandt ist und die Sichtbarkeit der Übergangsoberflächen von mindestens einem überwiegenden Teil der erweiterten Fläche durch die Fangplattenanordnung ($20_5$, $20_7$) versperrt wird.

39. Sputterbeschichtungskammer nach Anspruch 38, wobei der Substrathalter (106) konstruiert ist, um ein Substrat (104) entlang einer Halteebene zu halten, wobei die einander zugewandten Kanten (9, 10) parallel und linear sind und die Halteebene parallel oder geneigt zu einer Ebene ist, die durch die parallelen und linearen Kanten (9, 10) definiert ist.

40. Sputterbeschichtungskammer nach Anspruch 39, wobei die Halteebene und die Ebene, die durch die Kanten (9, 10) definiert ist, um höchstens 45° geneigt sind.

41. Sputterbeschichtungskammer nach mindestens einem der Ansprüche 38 bis 40, wobei das Substrat (104) auf dem Substrathalter (106) elektrisch schwebend betrieben wird oder mit einem DC-Referenzpotenzial, vorzugsweise dem Erdpotenzial, verbunden werden kann.

42. Sputterbeschichtungskammer nach mindestens einem der Ansprüche 38 bis 41, wobei der Substrathalter (106) konstruiert ist, um ein kreisförmiges Substrat (104) zu halten und mit einem Drehantrieb wirkverbunden ist, der den Substrathalter (106) um eine Mittelachse dreht.

43. Sputterbeschichtungskammer nach mindestens einem der Ansprüche 38 bis 42, umfassend einen Substrathalterträger mit mindestens zwei der Substrathalter, wobei die Anzahl der bereitgestellten Sputterquellen der Anzahl der mindestens zwei Substrathalter an dem Träger entspricht oder sich davon unterscheidet.

**44.** Sputtersystem, umfassend mindestens eine Sputterquelle nach mindestens einem der Ansprüche 1 bis 37 oder mindestens eine Sputterkammer nach mindestens einem der Ansprüche 38 bis 43, ferner umfassend eine Gaszufuhranordnung (102), die ein Gas in den Reaktionsraum der mindestens einen Sputterquelle und/oder zwischen dem offenen Beschichtungsmaterialauslassbereich der Sputterquelle und dem Substrathalter abgibt.

**45.** System nach Anspruch 44, wobei die Gaszufuhranordnung (102) in einer operativen Strömungsverbindung mit einer Gasreservoiranordnung steht, die ein Gas enthält, wobei das Gas oder mindestens eine Komponente davon in dem Sputterplasma als ein Ion vorliegt.

**46.** System nach mindestens einem der Ansprüche 44 oder 45, wobei die Gaszufuhranordnung (102) in einer operativen Strömungsverbindung mit einer Gasreservoiranordnung steht, die ein Gas enthält, wobei das Gas oder mindestens eine Komponente davon in dem Sputterplasma als ein negatives Ion vorliegt.

**47.** System nach mindestens einem der Ansprüche 44 bis 46, wobei die Gaszufuhranordnung (102) in einer operativen Strömungsverbindung mit einer Gasreservoiranordnung steht, die ein Gas enthält, wobei das Gas oder mindestens eine Komponente davon Sauerstoff ist.

**48.** Sputtersystem nach mindestens einem der Ansprüche 44 bis 47, wobei mindestens eines der Targets (5, 7, 8) elektrisch durch mindestens eine Versorgungsquelle versorgt wird, die mindestens eines von DC, gepulstem DC, RF erzeugt.

**49.** Verfahren zur Sputterbeschichtung eines Substrats mit einem Material, wobei mindestens eine Komponente davon in dem Sputterplasma als ein Ion vorliegt, oder zum Herstellen eines Substrats, das mit dem Material beschichtet ist, wobei die Verfahren das Aufbringen der Beschichtung mithilfe von mindestens einer Sputterquelle nach mindestens einem der Ansprüche 1 bis 37 oder mithilfe einer Sputterkammer nach mindestens einem der Ansprüche 38 bis 43 oder mithilfe eines Systems nach mindestens einem der Ansprüche 44 bis 48 umfassen.

**50.** Verfahren nach Anspruch 49, wodurch das Substrat mit einem Material beschichtet wird, wobei mindestens eine Komponente davon in dem Sputterplasma als ein negatives Ion vorliegt.

**51.** Verfahren nach mindestens einem der Ansprüche 49 oder 50, indem das Substrat mit einem Oxid beschichtet wird.

**52.** Verfahren nach mindestens einem der Ansprüche 49 bis 51, umfassend das Verhindern, dass die Ionen der Sputterquelle, die eine Energie von mindestens $0,5\,UAC \times e^-$ aufweisen, auf das Substrat auftreffen, durch die Fangplattenanordnung ($20_5$, $20_7$), wobei UAC der Zeitmittelwert des absoluten Werts der Anode/Targetspannung ist.

## Revendications

**1.** Source de pulvérisation (1) conçue pour revêtir par pulvérisation un substrat (104) comprenant :

• deux cibles en forme de plaque (5, 7) s'étendant le long de plans de plaque respectifs ($E_5$, $E_7$), les surfaces de pulvérisation ($S_5$, $S_7$) desdites cibles (5, 7) se faisant face et définissant ainsi, entre elles, un espace de réaction (R), lesdits plans de plaque ($E_5$, $E_7$) étant parallèles entre eux ou inclinés l'un par rapport à l'autre de 90° maximum ;
• un agencement d'anode (14, 14s, $14_7$) ;
• un agencement d'aimant (18s, $18_7$) le long de chacune desdites cibles (5, 7) et opposé aux surfaces de pulvérisation respectives ($S_5$, $S_7$), chaque agencement d'aimant ($18_5$, $18_7$) générant un champ magnétique dans ledit espace de réaction (R) venant impacter et/ou émanant de et réparti le long d'au moins une partie prédominante des surfaces de pulvérisation respectives ($S_5$, $S_7$) ;
• une zone de sortie de revêtement ouverte (12) depuis ledit espace de réaction (R) vers un espace de revêtement (S), limitée par les zones respectives des bords se faisant mutuellement face (9, 10) desdites deux cibles en forme de plaque (5, 7) ;
• lesdites surfaces de pulvérisation ($S_5$, $S_7$) desdites cibles (5, 7) transitant dans les zones de surface latérales respectives ($L_5$, $L_7$) desdites cibles (5, 7) le long desdits bords se faisant mutuellement face (9, 10) par les zones de surface de transition respectives ($T_5$, $T_7$) desdites cibles (5, 7), lesdites zones de surface de transition ($T_5$, $T_7$) ayant un rayon de courbure plus petit que les zones adjacentes de la surface de pulvérisation respective ($S_5$, $S_7$) ;
• un agencement de plaque de réception en saillie ($20_5$, $20_7$) le long de chacun desdits bords (9, 10) et distant de l'une desdites cibles (5, 7) et en saillie respectivement dans une direction depuis lesdits bords (9, 10) en direction l'une de l'autre dans ladite zone de sortie de revêtement ouverte (12), réduisant ainsi ladite zone de sortie de revêtement ouverte (12) limitée par lesdits bords se faisant mutuellement face (9, 10) desdites deux cibles en forme de plaque (5, 7), **caractérisée par le fait que**

• ledit agencement de plaque de réception en saillie ($20_5$, $20_7$) a une surface globale qui est composée principalement d'une première zone de surface étendue et d'une deuxième zone de surface étendue opposée, ladite première zone de surface étendue étant exposée exclusivement audit espace de réaction (R), tandis que ladite deuxième zone de surface étendue est exposée exclusivement audit espace de revêtement (S).

2. Source de pulvérisation selon la revendication 1 conçue pour revêtir par pulvérisation ledit substrat (104) avec un matériau, au moins un composant de ce dernier étant présent dans le plasma de pulvérisation sous la forme d'un ion.

3. Source de pulvérisation selon l'une des revendications 1 ou 2, conçue pour revêtir par pulvérisation ledit substrat (104) avec un matériau, au moins un composant de ce dernier étant présent dans le plasma de pulvérisation sous la forme d'un ion négatif.

4. Source de pulvérisation selon l'une des revendications 1 à 3, conçue pour revêtir par pulvérisation ledit substrat (104) avec un oxyde.

5. Source de pulvérisation selon au moins l'une des revendications 1 ou 4, dans laquelle chaque agencement de plaque de réception ($20_5$, $20_7$) a un bord davantage en saillie et dans laquelle la distance depuis ledit bord le plus en saillie jusqu'à une surface latérale de la cible respective (5, 7), mesurée dans un plan parallèle au plan de plaque respectif et perpendiculairement à l'étendue longitudinale dudit bord le plus en saillie, est plus petite que la distance entre ledit bord le plus en saillie et une surface de la cible respective (5, 7), mesurée dans un plan perpendiculaire audit plan de plaque respectif et perpendiculaire à ladite étendue longitudinale dudit bord le plus en saillie.

6. Source de pulvérisation selon au moins l'une des revendications 1 à 5, lesdits plans de plaque ($E_5$, $E_7$) étant symétriques à un plan central.

7. Source de pulvérisation selon au moins l'une des revendications 1 à 6, lesdits plans de plaque ($E_5$, $E_7$) étant parallèles.

8. Source de pulvérisation selon au moins l'une des revendications 1 à 7, dans laquelle lesdits bords se faisant mutuellement face (9, 10) sont linéaires et parallèles.

9. Source de pulvérisation selon au moins l'une des revendications 1 à 8, dans laquelle lesdites cibles en forme de plaque (5, 7) sont rectangulaires ou carrées.

10. Source de pulvérisation selon au moins l'une des revendications 1 à 9, lesdits plans de plaque ($E_5$, $E_7$) étant symétriques par rapport à un plan central, ladite zone de sortie de revêtement ouverte (12) s'étendant le long d'un plan perpendiculaire audit plan central.

11. Source de pulvérisation selon au moins l'une des revendications 1 à 10, au moins l'une des cibles (5, 7) étant composée d'un seul matériau.

12. Source de pulvérisation selon au moins l'une des revendications 1 à 11, au moins l'une desdites cibles (5, 7) comprenant un oxyde ou étant composée d'un oxyde.

13. Source de pulvérisation selon au moins l'une des revendications 1 à 12, au moins l'une desdites cibles (5, 7) comprenant un composant de matériau présent dans le plasma de pulvérisation sous la forme d'un ion.

14. Source de pulvérisation selon au moins l'une des revendications 1 à 13, au moins l'une desdites cibles (5, 7) comprenant un composant de matériau présent dans le plasma de pulvérisation sous la forme d'un ion négatif.

15. Source de pulvérisation selon au moins l'une des revendications 1 à 14, comprenant un agencement d'alimentation en gaz oxygène (102) se déversant dans ledit espace de réaction et/ou en aval de ladite zone de sortie de revêtement ouverte, limitée par ledit agencement de plaque de réception (205, 207).

16. Source de pulvérisation selon au moins l'une des revendications 1 à 15, comprenant un agencement d'alimentation en gaz (102) se déversant dans ledit espace de réaction (R) et/ou en aval de ladite zone de sortie de revêtement ouverte (12), limitée par ledit agencement de plaque de réception ($20_5$, $20_7$).

17. Source de pulvérisation selon au moins l'une des revendications 1 à 16, ledit agencement de plaque de réception ($20_5$, $20_7$) comprenant des plaques de réception ($20_5$, $20_7$) d'au moins une des formes suivantes : planes, courbées vers ledit espace de réaction, courbées à l'opposé dudit espace de réaction (R).

18. Source de pulvérisation selon au moins l'une des revendications 1 à 17, dans laquelle ledit agencement de plaque de réception ($20_5$, $20_7$) comprend au moins une plaque métallique ou est composé d'au moins une plaque métallique.

19. Source de pulvérisation selon au moins l'une des revendications 1 à 18, dans laquelle ledit agencement de plaque de réception ($20_5$, $20_7$) comprend au moins une plaque de matériau céramique ou est composé d'au moins une plaque de matériau céramique.

20. Source de pulvérisation selon au moins l'une des revendications 1 à 19, ledit agencement d'anode (14) comprenant une plaque d'anode latérale, complétant la délimitation sur deux côtés dudit espace de réaction (R) par lesdites deux cibles (5, 7) pour venir délimiter ledit espace de réaction (R) sur trois côtés.

21. Source de pulvérisation selon la revendication 20, comprenant deux desdites plaques d'anode latérales complétant la délimitation sur deux côtés dudit espace de réaction par lesdites deux cibles (5, 7) pour venir délimiter ledit espace de réaction sur quatre côtés.

22. Source de pulvérisation selon au moins l'une des revendications 1 à 21, ledit agencement d'anode (14) comprenant une plaque d'anode latérale, complétant la délimitation sur deux côtés de ladite zone de sortie de revêtement ouverte (12) par lesdites deux cibles (5, 7) pour venir délimiter ladite zone de sortie de revêtement ouverte (12) sur trois côtés.

23. Source de pulvérisation selon la revendication 22, ledit agencement d'anode (14) comprenant deux desdites plaques d'anode latérales, complétant la délimitation sur deux côtés de ladite zone de sortie de revêtement ouverte (12) par lesdites deux cibles (5, 7) pour venir délimiter ladite zone de sortie de revêtement ouverte (12) sur quatre côtés.

24. Source de pulvérisation selon au moins l'une des revendications 1 à 23, ledit agencement d'anode (14) comprenant une plaque d'anode opposée à ladite zone de sortie de revêtement ouverte (12) par rapport audit espace de réaction (R).

25. Source de pulvérisation selon au moins l'une des revendications 1 à 24, ledit agencement d'anode (14) comprenant un cadre d'anode autour de ladite zone de sortie de revêtement ouverte (12).

26. Source de pulvérisation selon au moins l'une des revendications 1 à 25, ledit agencement d'anode (14) comprenant un agencement de bandes d'anode le long du bord desdites cibles (5, 7) et exclusivement le long desdits bords se faisant face (9, 10).

27. Source de pulvérisation selon au moins l'une des revendications 1 à 26, ledit agencement d'anode (14) comprenant un agencement de bandes d'anode le long desdits bords se faisant mutuellement face (9, 10), ledit agencement de plaque de réception ($20_5$, $20_7$) comprenant des plaques métalliques en saillie raccordées électriquement et mécaniquement audites bandes d'anode.

28. Source de pulvérisation selon au moins l'une des revendications 1 à 27, ledit agencement de plaque de réception ($20_5$, $20_7$) comprenant des plaques métalliques en saillie raccordées électriquement audit agencement d'anode (14).

29. Source de pulvérisation selon au moins l'une des revendications 1 à 28, ledit agencement de plaque de réception ($20_5$, $20_7$) étant deux pieds d'un cadre délimitant et autour de ladite zone de sortie de revêtement ouverte (12).

30. Source de pulvérisation selon au moins l'une des revendications 1 à 29, ledit champ magnétique étant généré de façon unidirectionnelle depuis une surface de pulvérisation ($S_5$) sur l'autre surface de pulvérisation ($S_7$).

31. Source de pulvérisation selon au moins l'une des revendications 1 à 30, comprenant une troisième cible (8) couvrant ledit espace de réaction (r) opposé à ladite zone de sortie de revêtement ouverte (12).

32. Source de pulvérisation selon la revendication 31, ladite troisième cible (8) étant associée à un agencement d'aimant ($19_8$) générant le long de la surface de pulvérisation de ladite troisième cible (8) un champ magnétique magnétron.

33. Source de pulvérisation selon au moins l'une des revendications 1 à 32, au moins l'une desdites cibles (5, 7, 8) comprenant ou étant composée d'au moins l'un des métaux parmi In, Sn, Zn, Ga, Al.

34. Source de pulvérisation selon au moins l'une des revendications 1 à 33, au moins l'une desdites cibles (5, 7, 8) comprenant un composant de matériau qui est présent dans le plasma de pulvérisation sous la forme d'un ion.

35. Source de pulvérisation selon au moins l'une des revendications 1 à 34, au moins l'une desdites cibles (5, 7, 8) comprenant un composant de matériau qui est présent dans le plasma de pulvérisation sous la forme d'un ion négatif.

**36.** Source de pulvérisation selon au moins l'une des revendications 1 à 35, au moins l'une desdites cibles (5, 7, 8) comprenant ou étant composée d'un oxyde.

**37.** Source de pulvérisation selon au moins l'une des revendications 1 à 36, dans laquelle lesdits plans de plaque ($E_5$, $E_7$) sont mutuellement inclinés de 5° maximum.

**38.** Chambre de revêtement par pulvérisation (100) comprenant au moins une source de pulvérisation (1) selon au moins l'une des revendications 1 à 37, et comprenant en outre un porte-substrat (106) conçu pour maintenir un substrat (104) avec l'une de ses surfaces étendues exposée audit espace de revêtement (S), ledit porte-substrat (106) étant monté dans ladite chambre de revêtement par pulvérisation (100) dans une position dans laquelle ladite surface étendue fait face à ladite zone de sortie de revêtement ouverte limitée (12) et dans laquelle la visibilité desdites zones de surface de transition depuis au moins une partie prédominante de ladite surface étendue est barrée par ledit agencement de plaque de réception ($20_5$, $20_7$).

**39.** Chambre de revêtement par pulvérisation selon la revendication 38, dans laquelle ledit porte-substrat (106) est conçu pour maintenir un substrat (104) le long d'un plan de maintien, dans laquelle lesdits bords se faisant mutuellement face (9, 10) sont parallèles et linéaires et dans laquelle ledit plan de maintien est parallèle à ou incliné par rapport à un plan défini par lesdits bords parallèles et linéaires (9, 10).

**40.** Chambre de revêtement par pulvérisation selon la revendication 39, dans laquelle ledit plan de maintien et ledit plan défini par lesdits bords (9, 10) sont inclinés de 45° maximum.

**41.** Chambre de revêtement par pulvérisation selon au moins l'une des revendications 38 à 40, dans laquelle ledit substrat (104) sur ledit porte-substrat (106) est commandé de manière électriquement flottante ou peut être raccordé à un potentiel de référence DC, de préférence un potentiel de terre.

**42.** Chambre de revêtement par pulvérisation selon au moins l'une des revendications 38 à 41, ledit porte-substrat (106) étant conçu pour maintenir un substrat circulaire (104) et étant raccordé de façon opérationnelle à un entraînement rotatif faisant tourner ledit porte-substrat (106) autour d'un axe central.

**43.** Chambre de revêtement par pulvérisation selon au moins l'une des revendications 38 à 42, comprenant un support de porte-substrat avec au moins deux desdits porte-substrats, le nombre desdites sources de pulvérisation fournies étant identique ou différent du nombre desdits au moins deux porte-substrats sur ledit support.

**44.** Système de pulvérisation comprenant au moins une source de pulvérisation selon au moins l'une des revendications 1 à 37, ou au moins une chambre de pulvérisation selon au moins l'une des revendications 38 à 43, comprenant en outre un agencement d'alimentation en gaz (102) amenant un gaz dans l'espace de réaction de ladite au moins une source de pulvérisation, et/ou entre la zone de sortie de matériau de recouvrement ouverte de ladite source de pulvérisation et ledit porte-substrat.

**45.** Système selon la revendication 44, dans lequel ledit agencement d'alimentation en gaz (102) est en liaison d'écoulement opérationnelle avec un agencement de réservoir de gaz contenant un gaz, ledit gaz ou ledit au moins un composant de ce dernier étant présent dans le plasma de pulvérisation sous la forme d'un ion.

**46.** Système selon au moins l'une des revendications 44 ou 45, dans lequel ledit agencement d'alimentation en gaz (102) est en liaison d'écoulement opérationnelle avec un agencement de réservoir de gaz contenant un gaz, ledit gaz ou au moins un composant de ce dernier étant présent dans le plasma de pulvérisation sous la forme d'un ion négatif.

**47.** Système selon au moins l'une des revendications 44 à 46, dans lequel ledit agencement d'alimentation en gaz (102) est en liaison d'écoulement opérationnelle avec un agencement de réservoir de gaz contenant un gaz, ledit gaz ou au moins un composant de ce dernier étant de l'oxygène.

**48.** Système de pulvérisation selon au moins l'une des revendications 44 à 47, au moins l'une desdites cibles (5, 7, 8) étant alimentée électriquement par au moins une source d'alimentation générant au moins un courant parmi DC, DC pulsé, RF.

**49.** Procédé pour revêtir par pulvérisation un substrat avec un matériau, au moins un composant de ce dernier étant présent dans le plasma de pulvérisation sous la forme d'un ion, ou procédé pour fabriquer un substrat revêtu avec ledit matériau, les procédés consistant à appliquer ledit revêtement au moyen d'au moins une source de pulvérisation selon au moins l'une des revendications 1 à 37, ou au moyen d'une chambre de pulvérisation selon au moins l'une des revendications 38 à 43, ou au moyen d'un système selon au moins l'une des revendications 44 à 48.

**50.** Procédé selon la revendication 49, revêtant ledit substrat avec un matériau, au moins un composant de ce dernier étant présent dans le plasma de pulvérisation sous la forme d'un ion négatif.

**51.** Procédé selon au moins l'une des revendications 49 ou 50, revêtant ledit substrat avec un oxyde.

**52.** Procédé selon au moins l'une des revendications 49 à 51 consistant à bloquer par ledit agencement de plaque de réception ($20_5$, $20_7$) de ladite source de pulvérisation les ions ayant une énergie d'au moins 0,5 UAC $\times$ e- et à les empêcher de venir sur ledit substrat, dans lequel UAC est la moyenne temporelle de la valeur absolue de la tension anode/cible.

FIG.1

FIG. 2a

FIG. 2b

FIG. 2c

FIG. 2d

FIG. 2e

FIG.3

FIG.4

FIG.5

FIG.6

FIG.7

FIG.8

28

FIG.9

$E_{9,10}$

7

5

10

$E_z$

9

FIG.10

$18_7$

7

R

$\mathcal{D}$

12

$20_{mp}$

$C_{207}$

108

$20_7$

S

$C_{207}$

106

104

FIG.11

FIG.12

30

$14_c$

$5, 18_5$

$14_{d7}$

$7, 18_7$

$14_a$

$14_b$

$14_{d5}$

10    12    9

FIG.13

7

5

$18_5$

$18_7$

10    12    9

$14_{e5}$

$14_{e7}$

$20_5$

$20_7$

108

$C_{205}$    $C_{207}$

FIG.14

FIG.15

FIG.16

FIG.17

EP 3 526 810 B1

FIG.18

FIG.19

FIG.20

FIG.21

FIG.22

FIG.23

FIG.24

FIG.25

FIG.26

FIG.27

**EP 3 526 810 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2008308417 A1

**Non-patent literature cited in the description**

- **HAO LEI ; KEISUKE ICHIKAWA.** Investigation of Low-Damage Sputter-Deposition of ITO Films on Organic Emission Layer. *IEICE Trans. Electron.,* October 2008, vol. E91-C (10), 1658